# EUROPEAN PATENT APPLICATION

(11) **EP 4 709 090 A1**
(43) Date of publication of application: **11.03.2026**
(21) Application number: 25177868.4
(22) Date of filing: 21.05.2025
(51) Int. Cl.: H10D 84/82, H10D 84/05, H10D 30/47, H10D 8/00, H10D 62/17, H10D 64/23, H10D 62/85

(54) **SEMICONDUCTOR DEVICE**

(30) Priority: 09.09.2024 KR 20240122691
(71) Applicant: Samsung Electronics Co., Ltd., Suwon-si, Gyeonggi-do 16677 (KR)
(72) Inventor: KIM, Jin-Hwan, Suwon-si, Gyeonggi-do 16677 (KR); HWANG, In Jun, Suwon-si, Gyeonggi-do 16677 (KR)
(74) Representative: Kuhnen & Wacker Patent- und Rechtsanwaltsbüro PartG mbB

(57) **Abstract**

A semiconductor device includes a substrate (110), a bidirectional transistor (100), and a plurality of diode elements (510, 520, 530) electrically connected to the bidirectional transistor (100), and the bidirectional transistor (100) includes a main channel layer (132m), a main barrier layer (136m), a first gate electrode (G1, 151) and a second gate electrode (G2, 152), a first gate semiconductor layer (181) between the main barrier layer (136m) and the first gate electrode (G1, 151), a second gate semiconductor layer (182) between the main barrier layer (136m) and the second gate electrode (G2, 152), a first electrode (191) between the first gate electrode (G1, 151) and the second gate electrode (G2, 152), a second electrode (192) on one side of the first gate electrode (G1, 151), and a third electrode (193) on one side of the second gate electrode (G2, 152), and the plurality of diode elements (510, 520, 530) electrically connects the substrate (110) and the first electrode (191), the substrate (110) and the second electrode (192), and the substrate (110) and the third electrode (193), respectively.

## Description

### BACKGROUND OF THE INVENTION

In general, semiconductor devices are closely related to our daily lives. In particular, power semiconductor devices are becoming increasingly important in various fields, such as the transportation field, for example, electric vehicles, trains, and electric trams, renewable energy systems, for example, solar power generation and wind power generation, and mobile devices. Power semiconductor devices are semiconductor devices usable to handle high voltage or high current, and perform functions such as power conversion and control in large power systems and high-power electronic devices. Power semiconductor devices have the ability and durability to handle high power, allowing them to handle large amounts of current and withstand high voltages. For example, power semiconductor devices can handle voltages of hundreds to thousands of volts and currents of tens to thousands of amperes. Power semiconductor devices can improve the efficiency of electrical energy by minimizing power losses. Further, power semiconductor devices can be stably driven in environments such as high temperatures.

These power semiconductor devices can be categorized by their materials, such as SiC power semiconductor devices and GaN power semiconductor devices. Instead of conventional silicon (Si) wafers, SiC or GaN may be used to manufacture power semiconductor devices, whereby it is possible to compensate for the disadvantages of silicon having unstable characteristics at high temperatures. SiC power semiconductor devices are resistant to high temperatures and have low power loss, making them suitable for electric vehicles, renewable energy systems, and the like. GaN power semiconductor devices require high costs, but are efficient in terms of speed, making them suitable for fast charging of mobile devices and the like.

### SUMMARY

In general, in some aspects, the present disclosure is directed toward a semiconductor device having stable electrical characteristics and improved reliability.

According to some implementations, the present disclosure is directed to a semiconductor device that includes a substrate, a bidirectional transistor positioned on the substrate, and a plurality of diode elements electrically connected to the bidirectional transistor, and the bidirectional transistor includes a main channel layer positioned on the substrate, a main barrier layer positioned on the main channel layer and contains a material having an energy band gap different from that of the main channel layer, a first gate electrode and a second gate electrode positioned on the main barrier layer so as to be spaced apart from each other, a first gate semiconductor layer positioned between the main barrier layer and the first gate electrode, a second gate semiconductor layer positioned between the main barrier layer and the second gate electrode, a first electrode positioned between the first gate electrode and the second gate electrode and is electrically connected to the main channel layer, a second electrode positioned on one side of the first gate electrode and positioned apart from the first electrode, and a third electrode positioned on one side of the second gate electrode and positioned apart from the first electrode, and the plurality of diode elements electrically connects the substrate and the first electrode, the substrate and the second electrode, and the substrate and the third electrode, respectively.

According to some implementations, the present disclosure is directed to a semiconductor device that includes a substrate, a bidirectional transistor positioned on the substrate, and a first diode element electrically connected to the bidirectional transistor, and the bidirectional transistor includes a main channel layer positioned on the substrate, a main barrier layer positioned on the main channel layer and contains a material having an energy band gap different from that of the main channel layer, a first gate electrode and a second gate electrode positioned on the main barrier layer so as to be spaced apart from each other, a first gate semiconductor layer positioned between the main barrier layer and the first gate electrode, a second gate semiconductor layer positioned between the main barrier layer and the second gate electrode, a first electrode positioned between the first gate electrode and the second gate electrode and is electrically connected to the main channel layer, a second electrode positioned on one side of the first gate electrode and positioned apart from the first electrode, and a third electrode positioned on one side of the second gate electrode and positioned apart from the first electrode, and the first diode element includes the following: a sub channel layer positioned on the substrate, a sub barrier layer positioned on the sub channel layer and contains a material having an energy band gap different from that of the sub channel layer, a sub gate electrode positioned on the sub barrier layer, a sub gate semiconductor layer positioned between the sub barrier layer and the sub gate electrode, and a sub source electrode and a sub drain electrode that are positioned on opposite sides of the sub gate electrode and are connected to the sub channel layer, and the sub source electrode is connected to the sub gate electrode and is formed integrally with the first electrode.

According to some implementations, the present disclosure is directed to a semiconductor device that includes a substrate, a main channel layer positioned on the substrate, a main barrier layer positioned on the main channel layer and contains a material having an energy band gap different from that of the main channel layer, a first gate electrode to a third gate electrode that are positioned on the main barrier layer and are arranged apart from each other, a protective layer positioned on the main barrier layer and covers the first gate electrode to the third gate electrode, a first electrode and a second electrode that passes through the protective layer and the main barrier layer, is positioned on the main channel layer, and is positioned on opposite sides of the first gate electrode, a third electrode and a fourth electrode that passes through the protective layer and the main barrier layer, is positioned on the main channel layer, and is positioned on opposite sides of the third gate electrode, and a connection electrode positioned on the protective layer and connects the second electrode and the fourth electrode, and the second gate electrode is positioned between the second electrode and the third electrode.

### BRIEF DESCRIPTION OF THE DRAWINGS

Example implementations will be more clearly understood from the following detailed description, taken in conjunction with the accompanying drawings.
FIG. 1 is a block diagram illustrating an example of an electronic system including a semiconductor device according to some implementations.
FIGS. 2 and 3 are circuit diagrams illustrating an example of a semiconductor device according to some implementations.
FIGS. 4 and 5 are plan views illustrating an example of a semiconductor device according to some implementations.
FIGS. 6 and 7 are cross-sectional views taken along line A-A' of FIG. 5 according to some implementations.
FIG. 8 is a cross-sectional view taken along line B-B' of FIG. 5 according to some implementations.
FIG. 9 is a cross-sectional view taken along line C-C' of FIG. 5 according to some implementations.
FIG. 10 is a cross-sectional view taken along line D-D' of FIG. 5 according to some implementations.
FIG. 11 is a cross-sectional view illustrating an example of a semiconductor device according to some implementations and corresponding to the line A-A' of FIG. 5.
FIG. 12 is a cross-sectional view illustrating an example of a semiconductor device according to some implementations and corresponding to the line B-B' of FIG. 5.
FIG. 13 is a plan view illustrating an example of a semiconductor device according to some implementations.
FIG. 14 is a cross-sectional view taken along line E-E' of FIG. 13 according to some implementations.
FIG. 15 is a cross-sectional view illustrating an example of a semiconductor device according to some implementations and corresponding to line E-E' of FIG. 13.
FIG. 16 is a circuit diagram illustrating an example of a semiconductor device according to some implementations.
FIG. 17 is a plan view illustrating an example of a semiconductor device according to some implementations with reference to FIG. 16.
FIG. 18 is a circuit diagram illustrating an example of a semiconductor device according to some implementations.
FIG. 19 is a plan view illustrating an example of a semiconductor device according to some implementations with reference to FIG. 18.

### DETAILED DESCRIPTION

Hereinafter, example implementations will be explained in detail with reference to the accompanying drawings.

The drawings and description of the present disclosure are to be regarded as illustrative in nature and not restrictive. Like reference numerals designate like elements throughout the specification.

In addition, the size and thickness of the configurations shown in the drawings may be arbitrarily shown for understanding and ease of description, but the present disclosure is not necessarily limited thereto. In the drawings, the thickness of layers, films, panels, regions, etc., may be exaggerated for clarity. Further, in the drawings, for understanding and ease of description, the thickness of some layers and areas may be exaggerated.

Further, it will be understood that when an element, such as a layer, film, region, or substrate, is referred to as being "on" another element, it can be directly on the other element or intervening elements may also be present. Additionally, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity.

In addition, in the present disclosure, unless explicitly described to the contrary, the word "comprise", and variations, such as "comprises" or "comprising", will be understood to imply the inclusion of stated elements but not the exclusion of any other elements.

Further, in the present disclosure, when it is referred to as "on a plane", it means when a target part is viewed from above, and when it is referred to as "on a cross-section", it means when the cross-section obtained by cutting a target part vertically is viewed from the side.

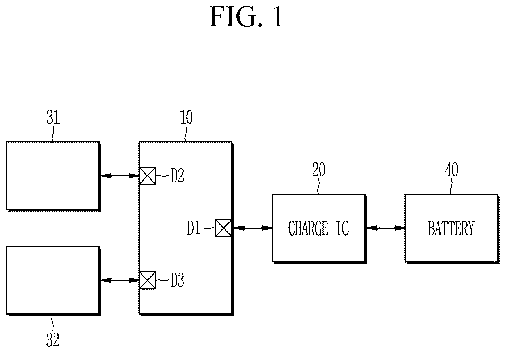

FIG. 1 is a block diagram illustrating an example of an electronic system including a semiconductor device according to some implementations. In FIG. 1, an electronic system may include an IC chip 20, a charger 40 electrically connected to the IC chip 20, a first terminal D1 to a third terminal D3, and a semiconductor device 10 that electrically connects the IC chip 20 and the second terminal D2 and electrically connects the IC chip 20 and the third terminal D3.

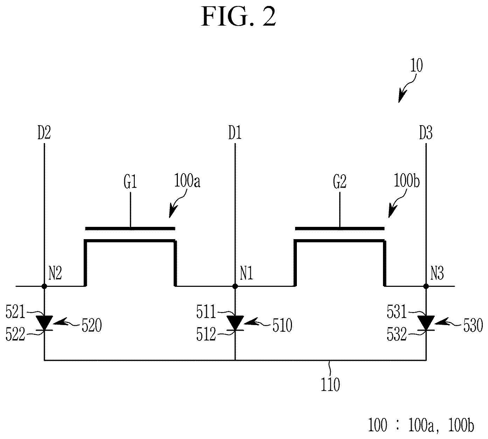

The IC chip 20 may be electrically connected to the charger 40. The IC chip 20 may be electrically connected to the semiconductor device 10 including a bidirectional transistor (reference symbol "100" in FIG. 2) through the first terminal D1.

The IC chip 20 may operate to charge or discharge the charger 40. For example, the IC chip 20 may receive power from the charger 40. The IC chip 20 may receive voltage and/or current necessary to charge devices 31 and 32 connected to the second terminal D2 and/or the third terminal D3, from the charger 40. Also, the IC chip 20 may transfer the power received through the second terminal D2 and/or the third terminal D3 to the charger 40. Further, the IC chip 20 may operate to charge or discharge the external devices 31 and 32 connected to the second terminal D2 and/or the third terminal D3. For example, the IC chip 20 may apply the power received from the charger 40 to the second terminal D2 and/or the third terminal D3. Also, the IC chip 20 may receive power from the devices 31 and 32 connected to the second terminal D2 and/or the third terminal D3. The IC chip 20 may transfer the power received from the devices 31 and 32 connected to the second terminal D2 and/or the third terminal D3, to the second terminal D2, the third terminal D3, and/or the charger 40. The IC chip 20 may apply a signal (for example, a turn-on signal or the like of first and second gate electrodes 151 and 152) for charging or discharging the external devices 31 and 32 connected to the second terminal D2 and/or the third terminal D3, to the semiconductor device 10.

The charger 40 may be electrically connected to the IC chip 20. The charger 40 may supply power to the IC chip 20. For example, the charger 40 may supply power necessary to charge the devices 31 and 32 connected to the second terminal D2 and/or the third terminal D3 to the IC chip 20. Also, the charger 40 may receive power through the IC chip 20. For example, the charger 40 may receive power, received by the devices 31 and 32 connected to the second terminal D2 and/or the third terminal D3, through the IC chip 20.

The semiconductor device 10 may be electrically connected to the IC chip 20. The semiconductor device 10 may be electrically connected to the IC chip 20 through the first terminal D1. Also, the semiconductor device 10 may be electrically connected to the external devices 31 and 32 through the second terminal D2 and the third terminal D3.

In some implementations, the semiconductor device 10 may include a normally-off high electron mobility transistor (HEMT) that operates bidirectionally. For example, the semiconductor device 10 may output power, applied from the charger 40 via the IC chip 20 and the first terminal D1, to the second terminal D2 and/or the third terminal D3, or may output power, applied from the second terminal D2, to the third terminal D3 and/or the first terminal D1, or may output power, applied from the third terminal D3, to the first terminal D1 and/or the second terminal D2. Accordingly, the external devices 31 and 32 electrically connected to the second terminal D2 and the third terminal D3 may be charged or discharged by the semiconductor device 10. However, the present disclosure is not limited thereto, and a semiconductor device 10 may be a normally-on high electron mobility transistor that operates bidirectionally.

The second terminal D2 and the third terminal D3 may be terminals to which the external devices 31 and 32 are electrically connected. The external devices 31 and 32 may be charged or discharged according to a signal which is applied to the IC chip 20. As an example, the second terminal D2 and the third terminal D3 may be USB power delivery terminals or wireless charging terminals; however, the present disclosure is not limited thereto. Here, the USB power delivery may refer to a protocol for supplying power to a device with a USB terminal through a USB cable.

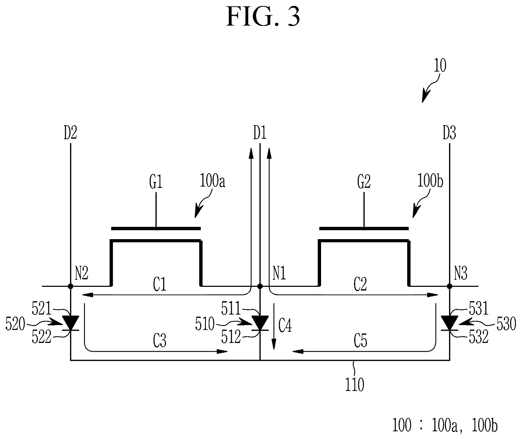

FIGS. 2 and 3 are circuit diagrams illustrating an example of a semiconductor device according to some implementations. FIG. 3 illustrates a current flow when a bidirectional transistor 100 and a plurality of diode elements 510, 520, and 530 are turned on.

In FIGS. 2 and 3, the semiconductor device 10 may include the bidirectional transistor 100, and the plurality of diode elements 510, 520, and 530 electrically connected to the bidirectional transistor 100.

The bidirectional transistor 100 may include the first terminal D1, the second terminal D2, the third terminal D3, a first gate electrode G1, and a second gate electrode G2. The bidirectional transistor 100 may include a plurality of transistors 100a and 100b each of which comprises a subset of the first terminal D1, the second terminal D2, the third terminal D3, the first gate electrode G1, and the second gate electrode G2. For example, the bidirectional transistor 100 may include a first transistor 100a comprising the first terminal D 1, the second terminal D2, and the first gate electrode G1, and a second transistor 100b comprising the first terminal D1, the third terminal D3, and the second gate electrode G2. The first transistor 100a and the second transistor 100b may share the first terminal D1.

The first transistor 100a may control current between the first terminal D1 and the second terminal D2 according to a gate signal which is applied to the first gate electrode G1. For example, when a turn-on signal is applied to the first gate electrode G1 of the first transistor 100a, current may flow along a first path C1 as shown in FIG. 3. In this case, current may bidirectionally flow between the first terminal D1 and the second terminal D2 according to the potential difference between the first terminal D1 and the second terminal D2. Further, the second transistor 100b may control current between the first terminal D1 and the third terminal D3 according to a gate signal which is applied to the second gate electrode G2. For example, when a turn-on signal is applied to the second gate electrode G2 of the second transistor 100b, current may flow along a second path C2 as shown in FIG. 3. In this case, current may bidirectionally flow between the first terminal D1 and the third terminal D3 according to the potential difference between the first terminal D1 and the third terminal D3. Accordingly, current may bidirectionally flow in the bidirectional transistor 100 according to a potential difference of the first terminal D1 to the third terminal D3.

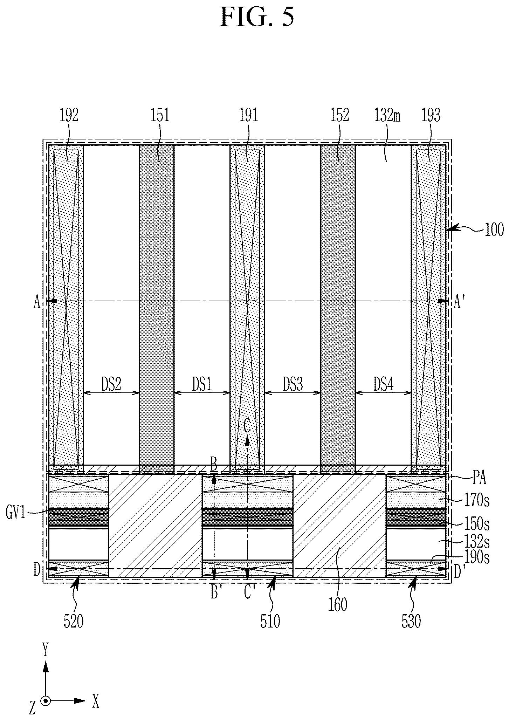

In some implementations, the first terminal D1 may refer to a terminal that is electrically connected to the IC chip 20 of FIG. 1, and the second terminal D2 and the third terminal D3 may refer to terminals that are electrically connected to the external devices (reference symbols "31" and "32" in FIG. 1) of FIG. 1, respectively. In some implementations, the first terminal D1 may correspond to a first electrode (reference symbol "191" in FIG. 5) shown in FIG. 5, and the second terminal D2 may correspond to a second electrode (reference symbol "192" in FIG. 5) shown in FIG. 5, and the third terminal D3 may correspond to a third electrode (reference symbol "193" in FIG. 5) shown in FIG. 5. Further, the first gate electrode G1 may correspond to a first gate electrode (reference symbol "151" in FIG. 5) shown in FIG. 5, and the second gate electrode G2 may correspond to a second gate electrode (reference symbol "152" in FIG. 5) shown in FIG. 5.

The plurality of diode elements 510, 520, and 530 may be electrically connected to the first terminal D1 to the third terminal D3, respectively. For example, the semiconductor device 10 may include the first diode element 510 electrically connected to the first terminal D1, the second diode element 520 electrically connected to the second terminal D2, and the third diode element 530 electrically connected to the third terminal D3.

The first diode element 510 to the third diode element 530 may be connected to a substrate 110. In other words, the first diode element 510 to the third diode element 530 may electrically connect the first terminal D1 to the third terminal D3 to the substrate 110. The first diode element 510 may electrically connect the first terminal D1 and the substrate 110, and the second diode element 520 may electrically connect the second terminal D2 and the substrate 110, and the third diode element 530 may electrically connect the third terminal D3 and the substrate 110.

Each of the first diode element 510 to the third diode element 530 may include an anode and a cathode. The anode 511 of the first diode element 510 may be electrically connected to the first terminal D1 through a first node N1. The cathode 512 of the first diode element 510 may be electrically connected to the substrate 110. The anode 521 of the second diode element 520 may be electrically connected to the second terminal D2 through a second node N2. The cathode 522 of the second diode element 520 may be electrically connected to the substrate 110. The anode 531 of the third diode element 530 may be electrically connected to the third terminal D3 through a third node N3. The cathode 532 of the third diode element 530 may be electrically connected to the substrate 110.

Accordingly, when a predetermined voltage is applied to the first terminal D1 to the third terminal D3, currents may flow along a third path C3 to a fifth path C5 as shown in FIG. 3. In this case, the magnitude of the currents which flow along the third path C3 to the fifth path C5, respectively, may each be smaller than the magnitude of the current which flows in the first transistor 100a and/or the second transistor 100b, and a voltage having a magnitude smaller than that for the first terminal D1 to the third terminal D3 may be applied to the substrate 110. Accordingly, when the first transistor 100a and/or the second transistor 100b is turned on, a current having a relatively small magnitude may flow in the first diode element 510 to the third diode element 530, respectively, and a voltage having a relatively small magnitude may be maintained on the substrate 110. Thus, the potential difference between the substrate 110 and the first terminal D1 to the third terminal D3 can be stably maintained, and it is possible to improve the reliability of the bidirectional transistor 100 which is included in the semiconductor device 10 and operates bidirectionally.

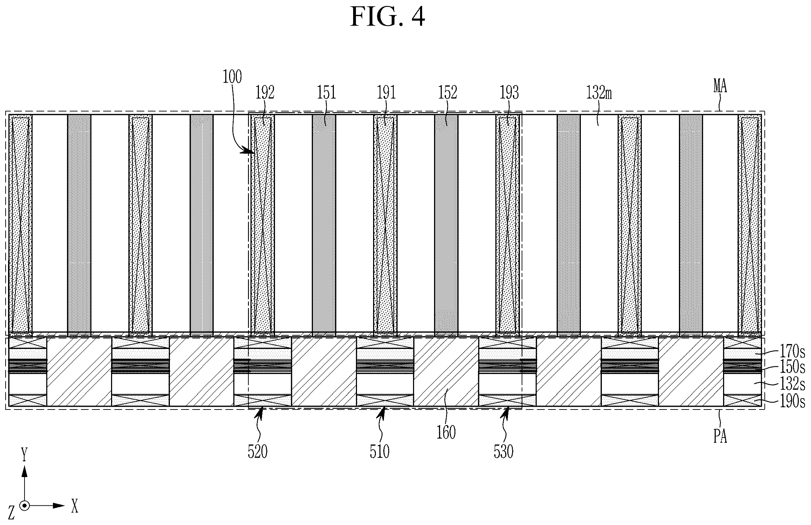

FIG. 4 is a plan view illustrating an example of a semiconductor device according to some implementations. In FIG. 4, the semiconductor device 10 may include a main element area MA that includes the bidirectional transistor 100, and a peripheral circuit area PA that includes the plurality of diode elements 510, 520, and 530.

In the main element area MA, the bidirectional transistor 100 may be positioned. For example, the bidirectional transistor 100 of the semiconductor device 10 may be a normally-off high electron mobility transistor (HEMT). However, the present disclosure is not limited thereto, and the bidirectional transistor 100 of the semiconductor device 10 may be a normally-on high electron mobility transistor. In some implementations, the main element area MA may refer to an area where the bidirectional transistor 100 is disposed.

In the main element area MA, a plurality of electrodes 191, 192, and 193 may be arranged so as to be spaced apart from each other. For example, the first electrode 191 to the third electrode 193 may extend in a second direction (a Y direction) and be spaced apart from each other in a first direction (an X direction). The first electrode 191 to the third electrode 193 may be arranged in the first direction (the X direction). Further, in the main element area MA, the plurality of gate electrodes 151 and 152 may be arranged so as to be spaced apart from each other. For example, the first gate electrode 151 and the second gate electrode 152 may extend in the second direction (the Y direction) and be spaced apart from each other in the first direction (the X direction). The first gate electrode 151 and the second gate electrode 152 may be repeatedly arranged in the first direction (the X direction).

On opposite sides of the first gate electrode 151, the first electrode 191 and the second electrode 192 may be positioned, and on opposite sides of the second gate electrode 152, the first electrode 191 and the third electrode 193 may be positioned. In other words, the first gate electrode 151 may be positioned between the first electrode 191 and the second electrode 192, and the second gate electrode 152 may be positioned between the first electrode 191 and the third electrode 193.

In some implementations, among the plurality of electrodes 191, 192, and 193 that is arranged in the first direction (the X direction) and the plurality of gate electrodes 151 and 152 that are arranged in the first direction (the X direction), the first electrode 191, the second electrode 192, the third electrode 193, the first gate electrode 151, and the second gate electrode 152 may constitute the bidirectional transistor 100. In other words, the bidirectional transistor 100 may comprise three electrodes, and two gate electrodes which are positioned between the electrodes. In some implementations, the main element area MA may include a plurality of bidirectional transistors 100; however, the present disclosure is not limited thereto. The plurality of bidirectional transistors 100 may be arranged in the first direction (the X direction).

The peripheral circuit area PA may be positioned on one side of the main element area MA. For example, as shown in FIG. 4, the peripheral circuit area PA may be positioned on one side of the main element area MA in the second direction (the Y direction); however, the present disclosure is not limited thereto.

The peripheral circuit area PA may include elements which are electrically connected to the bidirectional transistor 100. For example, in the peripheral circuit area PA, the plurality of diode elements 510, 520, and 530 which is electrically connected to the bidirectional transistor 100 may be positioned. In some implementations, one terminal of each of the plurality of diode elements 510, 520, and 530 may be electrically connected to the bidirectional transistor 100. The plurality of diode elements 510, 520, and 530 may be arranged in the first direction (the X direction). The plurality of diode elements 510, 520, and 530 may be positioned so as to be spaced apart from each other in the first direction (the X direction). In some implementations, the peripheral circuit area PA may refer to an area where the plurality of diode elements 510, 520, and 530 is disposed.

However, the present disclosure is not limited thereto, and as another example, in the peripheral circuit area PA, a passive element, such as a capacitor or an inductor, or an active element, such as an integrated circuit (IC) chip, may be further positioned. As another example, in the peripheral circuit area PA, a current divider, a voltage divider, a voltage clipper, a protection element for the bidirectional transistor 100, or the like may be further positioned.

Hereinafter, the bidirectional transistor of the semiconductor device will be described with reference to FIGS. 5 to 7.

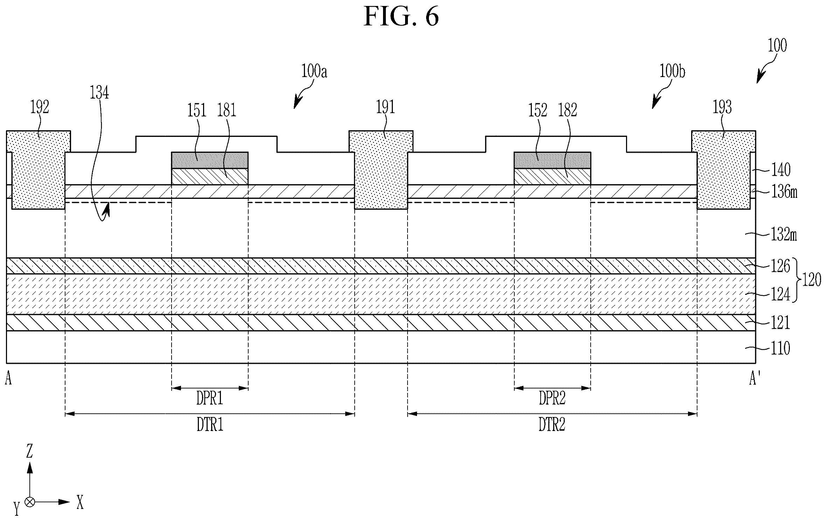

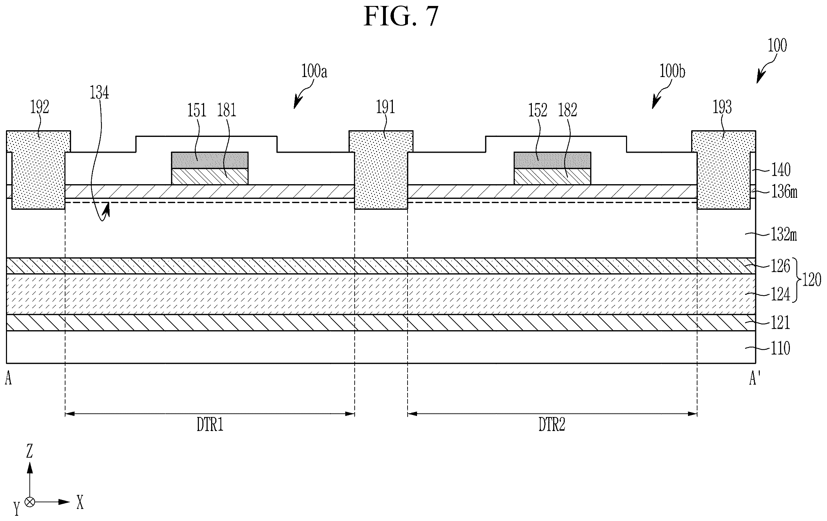

FIG. 5 is a plan view illustrating an example of a semiconductor device according to some implementations. FIGS. 6 and 7 are cross-sectional views taken along line A-A' of FIG. 5 according to some implementations. FIG. 6 illustrates when the semiconductor device is in the off state, and FIG. 7 illustrates when the semiconductor device is in the on state. In FIGS. 5 to 7, one bidirectional transistor 100 and three diode elements 510, 520, and 530 which are electrically connected to one bidirectional transistor 100 are shown for ease of explanation. Hereinafter, for ease of explanation, one bidirectional transistor 100, and three diode elements 510, 520, and 530 which are electrically connected to one bidirectional transistor 100 will be described.

In FIG. 5, the peripheral circuit area PA of the semiconductor device 10 may be positioned apart from the main element area MA. For example, the peripheral circuit area PA may be positioned apart from the main element area MA in the second direction (the Y direction); however, the present disclosure is not limited thereto. For example, the peripheral circuit area PA may be positioned apart from the main element area MA in the second direction (the Y direction), or may surround the side surface of the main element area MA. Of course, various other changes are possible. In some implementations, a separation structure 160 may be positioned between the peripheral circuit area PA and the main element area MA; however, the present disclosure is not limited thereto.

In FIGS. 5 and 6, the bidirectional transistor 100 of the semiconductor device 10 may include a main channel layer 132m, a main barrier layer 136m positioned on the main channel layer 132m, the first gate electrode 151 and the second gate electrode 152 that are positioned on the main barrier layer 136m, a first gate semiconductor layer 181 positioned between the main barrier layer 136m and the first gate electrode 151, a second gate semiconductor layer 182 positioned between the main barrier layer 136m and the second gate electrode 152, and the first electrode 191 to the third electrode 193 that are spaced apart from each other on the main channel layer 132m.

The main channel layer 132m may be a layer which forms a channel between the first electrode 191 and the second electrode 192 and between the first electrode 191 and the third electrode 193, and inside the main channel layer 132m, a 2-dimensional electron gas (2DEG) 134 may be positioned. The 2-dimensional electron gas 134 is a charge transfer model that is used in solid-state physics, and means a group of electrons that are tightly confined in two dimensions (for example, in directions on an x-y plane) such that they are free to migrate in the two dimensions but cannot migrate in the other dimensions (for example, in a z direction). In other words, the 2-dimensional electron gas 134 may exist in a form like a two-dimensional sheet in a three-dimensional space. Such 2-dimensional electron gases 134 mainly appear in semiconductor heterojunction structures, and in the semiconductor device 10, the 2-dimensional electron gas 134 may occur at the interface between the main channel layer 132m and the main barrier layer 136m. For example, the 2-dimensional electron gas 134 may occur at a portion inside the main channel layer 132m adjacent to the main barrier layer 136m.

The main channel layer 132m may contain at least one material selected from III-V materials such as nitrides containing Al, Ga, In, B, or a combination thereof. The main channel layer 132m may comprise a single layer or multiple layers. The main channel layer 132m may be formed of AlₓIn_{y}Ga_{1-x-y}N (wherein 0≤x≤1, 0≤y≤1, and x+y≤1). For example, the main channel layer 132m may contain AlN, GaN, InN, InGaN, AlGaN, AlInN, AlInGaN, or a combination thereof. The main channel layer 132m may be a layer doped with impurities, or may be a layer undoped with impurities. The thickness of the main channel layer 132m may be about hundreds of nm or less.

The main channel layer 132m may be positioned on the substrate 110, and between the substrate 110 and the main channel layer 132m, a seed layer 121 and a buffer layer 120 may be positioned. The substrate 110, the seed layer 121, and the buffer layer 120 may be layers necessary to form the main channel layer 132m, and may be omitted in some cases. For example, when a substrate made of GaN is used as the main channel layer 132m, at least one of the substrate 110, the seed layer 121, and the buffer layer 120 may be omitted. In consideration of the relatively high prices of substrates made of GaN, a substrate 110 made of Si may be used to grow a main channel layer 132m containing GaN. In this case, since the lattice structure of Si and the lattice structure of GaN are different, it may not be easy to grow the main channel layer 132m directly on the substrate 110. Accordingly, a seed layer 121 and a buffer layer 120 may be first grown on the substrate 110, and then the main channel layer 132m may be grown on the buffer layer 120. Also, at least one of the substrate 110, the seed layer 121, and the buffer layer 120 may be removed from the final structure of the semiconductor device 10 after being used in the manufacturing process.

The substrate 110 may contain a semiconductor material. For example, the substrate 110 may contain sapphire, Si, SiC, AlN, GaN, or a combination thereof. The substrate 110 may be a silicon-on-insulator (SOI) substrate. However, the material of the substrate 110 is not limited thereto, and every substrate which is generally used may be applied. In some cases, the substrate 110 may contain an insulating material. For example, several layers including the main channel layer 132m may be formed on a semiconductor substrate first, and then the semiconductor substrate may be removed and replaced with an insulating substrate.

The seed layer 121 may be positioned directly on the substrate 110. However, the present disclosure is not limited thereto, and between the substrate 110 and the seed layer 121, other predetermined layers may be further positioned. The seed layer 121 is a layer to serve as a seed for growing the buffer layer 120, and may be formed of a crystal lattice structure to be a seed for the buffer layer 120. The seed layer 121 may contain at least one material selected from III-V materials such as nitrides containing Al, Ga, In, B, or a combination thereof. The seed layer 121 may be formed of AlₓIn_{y}Ga_{1-x-y}N (wherein 0≤x≤1, 0≤y≤1, and x+y≤1). For example, the seed layer 121 may contain AlN, GaN, InN, InGaN, AlGaN, AlInN, AlInGaN, or a combination thereof.

The buffer layer 120 may be positioned on the seed layer 121. The buffer layer 120 may be positioned between the seed layer 121 and the main channel layer 132m. The buffer layer 120 may be a layer for mitigating differences in lattice constant and thermal expansion coefficient between the seed layer 121 and the main channel layer 132m or preventing parasitic current (leakage current) from flowing through the main channel layer 132m. The buffer layer 120 may contain at least one material selected from III-V materials such as nitrides containing Al, Ga, In, B, or a combination thereof. The buffer layer 120 may be formed of AlₓIn_{y}Ga_{1-x-y}N (wherein 0≤x≤1, 0≤y≤1, and x+y≤1). For example, the buffer layer 120 may contain AlN, GaN, InN, InGaN, AlGaN, AlInN, AlInGaN, or a combination thereof.

The buffer layer 120 of the semiconductor device 10 may include a superlattice layer 124 positioned on the seed layer 121, and a high-resistivity layer 126 positioned on the superlattice layer 124. The superlattice layer 124 and the high-resistivity layer 126 may be sequentially positioned on the substrate 110.

The superlattice layer 124 may be positioned on the seed layer 121. The superlattice layer 124 may be positioned directly on the seed layer 121. However, the present disclosure is not limited thereto, and between the seed layer 121 and the superlattice layer 124, other predetermined layers may be further positioned. The superlattice layer 124 is a layer for migrating differences in lattice constant and thermal expansion coefficient between the substrate 110 and the main channel layer 132m, thereby relieving tensile stress and compressive stress that is generated between the substrate 110 and the main channel layer 132m and relieving stress between all layers formed by growth in the final structure of the semiconductor device 10 according to the embodiment. The superlattice layer 124 may contain at least one material selected from III-V materials such as nitrides containing Al, Ga, In, B, or a combination thereof. The superlattice layer 124 may be formed of AlₓIn_{y}Ga_{1-x-y}N (wherein 0≤x≤1, 0≤y≤1, and x+y≤1). For example, the superlattice layer 124 may contain AlN, GaN, InN, InGaN, AlGaN, AlInN, AlInGaN, or a combination thereof.

In some implementations, the superlattice layer 124 may comprise multiple layers containing different materials and alternately stacked. For example, the superlattice layer 124 may have a structure in which layers comprising of AlGaN and layers comprising of AlN are alternately stacked. In other words, AlGaN, AlN, AlGaN, AlN, AlGaN, and AlN are sequentially stacked to form the superlattice layer. The numbers of AlGaN layers and AlN layers which constitute the superlattice layer 124 may be variously changed, and the materials which constitute the superlattice layer 124 may be variously changed. As another example, the superlattice layer 124 may have a structure in which layers comprising of AlGaN and layers comprising of GaN are alternately stacked. In other words, AlGaN, GaN, AlGaN, GaN, AlGaN, and GaN are sequentially stacked to form the superlattice layer. In some implementations, when the superlattice layer 124 contains GaN, InN, AlGaN, AlInN, InGaN, AlN, AlInGaN, a combination thereof, etc., the superlattice layer 124 may have an n-type semiconductor characteristic in which the concentration of electrons is greater than the concentration of holes; however, the present disclosure is not limited thereto.

The high-resistivity layer 126 may be positioned on the superlattice layer 124. The high-resistivity layer 126 may be positioned directly on the superlattice layer 124. However, the present disclosure is not limited thereto, and between the superlattice layer 124 and the high-resistivity layer 126, other predetermined layers may be further positioned. The high-resistivity layer 126 may be positioned between the superlattice layer 124 and the main channel layer 132m. The high-resistivity layer 126 is a layer for preventing leakage current from flowing through the main channel layer 132m, thereby preventing the semiconductor device 10 from being deteriorated. The high-resistivity layer 126 may comprise a material having low conductivity, such that the substrate 110 and the main channel layer 132m can be electrically insulated from each other. The high-resistivity layer may contain at least one material selected from III-V materials, such as nitrides containing Al, Ga, In, B, or a combination thereof. The high-resistivity layer 126 may be formed of AlₓIn_{y}Ga_{1-x-y}N (wherein 0≤x≤1, 0≤y≤1, and x+y≤1). For example, the high-resistivity layer 126 may contain AlN, GaN, InN, InGaN, AlGaN, AlInN, AlInGaN, or a combination thereof. The high-resistivity layer 126 may comprise a single layer or multiple layers.

The main barrier layer 136m may be positioned on the main channel layer 132m. The main barrier layer 136m may be positioned directly on the main channel layer 132m. However, the present disclosure is not limited thereto, and between the main channel layer 132m and the main barrier layer 136m, other predetermined layers may be further positioned. Regions of the main channel layer 132m overlapping the main barrier layer 136m between the first electrode 191 and the second electrode 192 and between the first electrode 191 and the third electrode 193 may become drift regions. For example, a first drift region DTR1 may be positioned between the first electrode 191 and the second electrode 192, and a second drift region DTR2 may be positioned between the first electrode 191 and the third electrode 193. The first drift region DTR1 may refer to a region in which carriers migrate when a potential difference occurs between the first electrode 191 and the second electrode 192. The second drift region DTR2 may refer to a region in which carriers migrate when a potential difference occurs between the first electrode 191 and the third electrode 193.

The semiconductor device 10 may be turned on and off according to whether voltage is applied to the first gate electrode 151 and/or the second gate electrode 152 and/or the magnitude of voltage which is applied to the first gate electrode 151 and/or the second gate electrode 152, whereby migration of carriers in the first and second drift regions DTR1 and DTR2 may be enabled or blocked.

The main barrier layer 136m may contain at least one material selected from III-V materials such as nitrides containing Al, Ga, In, B, or a combination thereof. The main barrier layer 136m may be formed of AlₓIn_{y}Ga_{1-x-y}N (wherein 0≤x≤1, 0≤y≤1, and x+y≤1). The main barrier layer 136m may contain GaN, InN, AlGaN, AlInN, InGaN, AlN, AlInGaN, a combination thereof, etc. The energy band gap of the main barrier layer 136m may be adjusted by the composition ratio of at least one of Al and In. The main barrier layer 136m may be doped with a predetermined impurity. In this case, the impurity with which the main barrier layer 136m is doped may be a p-type dopant capable of providing holes. For example, the impurity with which the main barrier layer 136m is doped may be magnesium (Mg). By increasing or decreasing the concentration of the impurity with which the main barrier layer 136m is doped, the threshold voltage, impedance, and the like of the semiconductor device 10 according to the embodiment may be adjusted.

The main barrier layer 136m may contain a semiconductor material having different characteristics from those of the main channel layer 132m. At least one of the polarization characteristics, energy band gap, and lattice constant of the main barrier layer 136m may be different from that of the main channel layer 132m. For example, the main barrier layer 136m may contain a material having an energy band gap different from that of the main channel layer 132m. In this case, the main barrier layer 136m may have an energy band gap higher than that of the main channel layer 132m, and may have electrical polarizability higher than that of the main channel layer 132m. By this main barrier layer 136m, the 2-dimensional electron gas 134 may be induced in the main channel layer 132m having relatively low electrical polarizability. In this regard, the main barrier layer 136m may be referred to as a channel supply layer or a 2-dimensional electron gas supply layer. The 2-dimensional electron gas 134 may be formed in a portion of the main channel layer 132m positioned below the interface between the main channel layer 132m and the main barrier layer 136m. The 2-dimensional electron gas 134 may have very high electron mobility.

The main barrier layer 136m may comprise a single layer or multiple layers. When the main barrier layer 136m comprises multiple layers, the materials of the individual layers constituting the multiple layers may have different energy band gaps. In this case, the multiple layers constituting the main barrier layer 136m may be disposed such that a layer closer to the main channel layer 132m has a higher energy band gap.

The first gate electrode 151 and the second gate electrode 152 may be positioned on the main barrier layer 136m. In some implementations, the first gate electrode 151 and the second gate electrode 152 may extend in the second direction (the Y direction). The first gate electrode 151 and the second gate electrode 152 may be positioned so as to be spaced apart from each other in the first direction (the X direction).

The first gate electrode 151 and the second gate electrode 152 may overlap a partial area of the main barrier layer 136m in the third direction (the Z direction). The first gate electrode 151 may overlap a portion of the first drift region DTR1 of the main channel layer 132m in a third direction (a Z direction). The second gate electrode 152 may overlap a portion of the second drift region DTR2 of the main channel layer 132m in the third direction (the Z direction). The first gate electrode 151 may be positioned between the first electrode 191 and the second electrode 192 to be described below. The first gate electrode 151 may be spaced apart from the first electrode 191 and the second electrode 192, which will be described below, in the first direction (the X direction). The second gate electrode 152 may be positioned between the first electrode 191 and the third electrode 193 to be described below. The second gate electrode 152 may be spaced apart from the first electrode 191 and the third electrode 193, which will be described below, in the first direction (the X direction).

The first gate electrode 151 and the second gate electrode 152 may be formed simultaneously in the same process. The first gate electrode 151 and the second gate electrode 152 may be positioned in the same layer. The upper surface of the first gate electrode 151 may be positioned substantially at the same level as that of the upper surface of the second gate electrode 152; however, the present disclosure is not limited thereto. In other words, the upper surface of the first gate electrode 151 and the upper surface of the second gate electrode 152 may be positioned substantially at the same distance from the upper surface of the substrate 110.

The first gate electrode 151 and the second gate electrode 152 may contain a conductive material. For example, the first gate electrode 151 and the second gate electrode 152 may contain a metal, a metal alloy, a conductive metal nitride, a metal silicide, a doped semiconductor material, a conductive metal oxide, a conductive metal oxynitride, or the like. For example, the first gate electrode 151 and the second gate electrode 152 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The first gate electrode 151 and the second gate electrode 152 may comprise a single layer or multiple layers.

In some implementations, a hard mask layer positioned on the first gate electrode 151 and the second gate electrode 152 may be further included. The hard mask layer may be a hard mask used to perform patterning on a gate electrode material layer or a gate semiconductor material layer in the procedure of forming the first gate electrode 151 and the second gate electrode 152. However, the hard mask layer may be removed according to an etching condition during etching on the gate electrode material layer or the gate semiconductor material layer, or a cleaning condition after the etching. As an example, the hard mask layer may contain a silicon oxide, a silicon nitride, a silicon oxynitride, or a combination thereof.

The first gate semiconductor layer 181 may be positioned between the main barrier layer 136m and the first gate electrode 151. The second gate semiconductor layer 182 may be positioned between the main barrier layer 136m and the second gate electrode 152. In other words, the first gate semiconductor layer 181 and the second gate semiconductor layer 182 may be positioned on the main barrier layer 136m, and the first gate electrode 151 and the second gate electrode 152 may be positioned on the first gate semiconductor layer 181 and the second gate semiconductor layer 182.

The first gate electrode 151 may be brought into Schottky contact or ohmic contact with the first gate semiconductor layer 181. The first gate semiconductor layer 181 may overlap the first gate electrode 151 in the third direction (the Z direction). In this case, the first gate semiconductor layer 181 may completely overlap the first gate electrode 151 in the third direction (the Z direction), and the upper surface of the first gate semiconductor layer 181 may be entirely covered by the first gate electrode 151. In other words, the first gate semiconductor layer 181 may have substantially the same plane shape as that of the first gate electrode 151.

In some implementations, the first gate semiconductor layer 181 may be positioned between the first electrode 191 and the second electrode 192. The first gate semiconductor layer 181 may be spaced apart from the first electrode 191 and the second electrode 192.

The second gate electrode 152 may be brought into Schottky contact or ohmic contact with the second gate semiconductor layer 182. The second gate semiconductor layer 182 may overlap the second gate electrode 152 in the third direction (the Z direction). In this case, the second gate semiconductor layer 182 may completely overlap the second gate electrode 152 in the third direction (the Z direction), and the upper surface of the second gate semiconductor layer 182 may be entirely covered by the second gate electrode 152. In other words, the second gate semiconductor layer 182 may have substantially the same plane shape as that of the second gate electrode 152.

However, the present disclosure is not limited thereto, and the first gate electrode 151 and the second gate electrode 152 may be positioned so as to cover at least a portion of the first gate semiconductor layer 181 and the second gate semiconductor layer 182.

In some implementations, the second gate semiconductor layer 182 may be positioned between the first electrode 191 and the third electrode 193. The second gate semiconductor layer 182 may be spaced apart from the first electrode 191 and the third electrode 193.

The first gate semiconductor layer 181 and the second gate semiconductor layer 182 may be formed simultaneously in the same process. The first gate semiconductor layer 181 and the second gate semiconductor layer 182 may be positioned in the same layer. The upper surface of the first gate semiconductor layer 181 may be positioned substantially at the same level as that of the upper surface of the second gate semiconductor layer 182; however, the present disclosure is not limited thereto. In other words, the upper surface of the first gate semiconductor layer 181 and the upper surface of the second gate semiconductor layer 182 may be positioned substantially at the same distance from the upper surface of the substrate 110.

The first gate semiconductor layer 181 and the second gate semiconductor layer 182 may contain at least one material selected from III-V materials, such as nitrides containing Al, Ga, In, B, or a combination thereof. The first gate semiconductor layer 181 and the second gate semiconductor layer 182 may be formed of AlₓIn_{y}Ga_{1-x-y}N (wherein 0≤x≤1, 0≤y≤1, and x+y≤1). For example, the first gate semiconductor layer 181 and the second gate semiconductor layer 182 may contain AlN, GaN, InN, InGaN, AlGaN, AlInN, AlInGaN, or a combination thereof. The first gate semiconductor layer 181 and the second gate semiconductor layer 182 may contain a material having an energy band gap different from that of the main barrier layer 136m. For example, the first gate semiconductor layer 181 and the second gate semiconductor layer 182 may contain GaN, and the main barrier layer 136m may contain AlGaN. The first gate semiconductor layer 181 and the second gate semiconductor layer 182 may be doped with a predetermined impurity. In this case, the impurity with which the first gate semiconductor layer 181 and the second gate semiconductor layer 182 are doped may be a p-type dopant capable of providing holes. For example, the first gate semiconductor layer 181 and the second gate semiconductor layer 182 may contain GaN doped with a p-type impurity. In other words, the first gate semiconductor layer 181 and the second gate semiconductor layer 182 may comprise a p-GaN layer. The first gate semiconductor layer 181 and the second gate semiconductor layer 182 may comprise a single layer or multiple layers.

By the first gate semiconductor layer 181 and the second gate semiconductor layer 182, a depletion region may be formed inside the main channel layer 132m. For example, a first depletion region DPR1 may be formed inside the main channel layer 132m by the first gate semiconductor layer 181, and a second depletion region DPR2 may be formed inside the main channel layer 132m by the second gate semiconductor layer 182. The first depletion region DPR1 may be positioned inside the first drift region DTR1, and may have a width smaller than that of the first drift region DTR1. The second depletion region DPR2 may be positioned inside the second drift region DTR2, and may have a width smaller than that of the second drift region DTR2. As the first gate semiconductor layer 181 and the second gate semiconductor layer 182 having an energy band gap different from that of the main barrier layer 136m are positioned on the main barrier layer 136m, the level of the energy band of a portion of the main barrier layer 136m overlapping the first gate semiconductor layer 181 and the second gate semiconductor layer 182 may be raised.

Accordingly, the depletion regions DPR1 and DPR2 may be formed in regions of the main channel layer 132m overlapping the first gate semiconductor layer 181 and the second gate semiconductor layer 182. The depletion regions DPR1 and DPR2 may be regions on the channel path of the main channel layer 132m where the 2-dimensional electron gas 134 is not formed or which has an electron concentration lower than that of the other regions. In other words, the depletion regions DPR1 and DPR2 may refer to regions in the drift regions DTR1 and DTR2 where the flow of the 2-dimensional electron gas 134 is cut. As the depletion regions DPR1 and DPR2 are generated, no current may flow between the first electrode 191 and the second electrode 192 and between the first electrode 191 and the third electrode 193, and the channel path may be blocked. Accordingly, the semiconductor device 10 may have a normally-off characteristic.

In some implementations, the semiconductor device 10 may be a normally-off high electron mobility transistor (HEMT). As shown in FIG. 6, in a normal state in which voltage is not applied to the first gate electrode 151 and the second gate electrode 152, the depletion regions DPR1 and DPR2 may exist, and the semiconductor device 10 according to the embodiment may be in the off state. As shown in FIG. 7, when a voltage equal to or higher than a threshold voltage is applied to the first gate electrode 151 and the second gate electrode 152, the depletion regions DPR1 and DPR2 may disappear, and the 2-dimensional electron gas 134 may continue inside the drift regions DTR1 and DTR2, without being cut. In other words, the 2-dimensional electron gas 134 may be formed over the entire channel path between the first electrode 191 and the second electrode 192 and between the first electrode 191 and the third electrode 193, and the semiconductor device 10 may be turned on. In summary, the semiconductor device 10 may include semiconductor layers having different electrical polarization characteristics, and a semiconductor layer having relatively high polarizability may cause the 2-dimensional electron gas 134 in another semiconductor layer forming a heterojunction with it. This 2-dimensional electron gas 134 may be used as a channel between the first electrode 191 and the second electrode 192 and between the first electrode 191 and the third electrode 193, and the continuation or interruption of the flow of the 2-dimensional electron gas 134 may be controlled by a bias voltage that is applied to the first gate electrode 151 and the second gate electrode 152.

Although it has been described above that the semiconductor device 10 is a normally-off high electron mobility transistor, the present disclosure is not limited thereto. For example, the semiconductor device 10 may be a normally-on high electron mobility transistor. When the semiconductor device is a normally-on high electron mobility transistor, the first gate semiconductor layer 181 and the second gate semiconductor layer 182 may be omitted, whereby the first gate electrode 151 and the second gate electrode 152 may be positioned directly on the main barrier layer 136m. In other words, the first gate electrode 151 and the second gate electrode 152 may be in contact with the main barrier layer 136m. In this structure, in a state where no voltage is applied to the first gate electrode 151 and the second gate electrode 152, the 2-dimensional electron gas 134 may be used as a channel, and a flow of current may occur between the first electrode 191 and the second electrode 192 and between the first electrode 191 and the third electrode 193. Further, when a negative voltage is applied to the first gate electrode 151 and the second gate electrode 152, depletion regions where the flow of the 2-dimensional electron gas 134 is cut off may occur under the first gate electrode 151 and the second gate electrode 152.

The seed layer 121, the superlattice layer 124, the high-resistivity layer 126, the main channel layer 132m, the main barrier layer 136m, the first gate semiconductor layer 181, and the second gate semiconductor layer 182 described above may be sequentially stacked on the substrate 110. In the semiconductor device 10, at least one of the seed layer 121, the superlattice layer 124, the high-resistivity layer 126, the main channel layer 132m, the main barrier layer 136m, the first gate semiconductor layer 181, and the second gate semiconductor layer 182 may be omitted. The seed layer 121, the superlattice layer 124, the high-resistivity layer 126, the main channel layer 132m, the main barrier layer 136m, the first gate semiconductor layer 181, and the second gate semiconductor layer 182 may comprise semiconductor materials based on the same materials, and the material composition ratios of the individual layers may be different from one another in view of the roles of the individual layers, the performance required for the semiconductor device 10, and the like.

The semiconductor device 10 may further include a first protective layer 140 which is positioned on the main barrier layer 136m. The first protective layer 140 may be positioned on the main barrier layer 136m, the first gate electrode 151, and the second gate electrode 152. The first protective layer 140 may cover the upper surfaces and side surfaces of the gate electrodes 151 and 152 and the side surfaces of the gate semiconductor layers 181 and 182. The lower surface of the first protective layer 140 may be in contact with the main barrier layer 136m and the gate electrodes 151 and 152. Accordingly, the main barrier layer 136m, the gate semiconductor layers 181 and 182, and the gate electrodes 151 and 152 may be protected by the first protective layer 140. However, the present disclosure is not limited thereto, and the gate electrodes 151 and 152 may pass through the first protective layer 140 and be connected to the gate semiconductor layers 181 and 182, and the first protective layer 140 may not cover the upper surfaces of the gate electrodes 151 and 152. Also, the lower surface of the first protective layer 140 may be in contact with the gate semiconductor layers 181 and 182. The first protective layer 140 may contain an insulating material. For example, the first protective layer 140 may contain an oxide such as SiO₂ or Al₂O₃. As another example, the first protective layer 140 may contain a nitride such as SiN, or an oxynitride such as SiON.

In FIGS. 5 and 6, the first protective layer 140 comprises a single layer. However, the first protective layer 140 is not limited thereto, and may comprise multiple layers containing different materials.

The first electrode 191 to the third electrode 193 may be positioned on the main channel layer 132m. The first electrode 191 to the third electrode 193 may be in direct contact with the main channel layer 132m, and may be electrically connected to the main channel layer 132m.

The first electrode 191 to the third electrode 193 may be spaced apart from each other. The first electrode 191 to the third electrode 193 may be positioned apart from each other in the first direction (the X direction). The first electrode 191 to the third electrode 193 may extend in directions parallel with each other. For example, the first electrode 191 to the third electrode 193 may extend in the second direction (the Y direction); however, the present disclosure is not limited thereto.

Specifically, the first electrode 191 and the second electrode 192 may be positioned on opposite sides of the first gate electrode 151. Between the first electrode 191 and the second electrode 192, the first gate electrode 151 and the first gate semiconductor layer 181 may be positioned. The first gate electrode 151 and the first gate semiconductor layer 181 may be spaced apart from the first electrode 191 and the second electrode 192 in the first direction (the X direction). For example, the first electrode 191 may be electrically connected to the main channel layer 132m on one side of the first gate electrode 151 in the first direction (the X direction), and the second electrode 192 may be electrically connected to the main channel layer 132m on the other side of the first gate electrode 151 in the first direction (the X direction). The first electrode 191 and the second electrode 192 may be positioned on the outside of the first drift region DTR1 of the main channel layer 132m. The interface between the first electrode 191 and the main channel layer 132m may be one edge of the first drift region DTR1. Similarly, the interface between the second electrode 192 and the main channel layer 132m may be the other edge of the first drift region DTR1. In this case, the first distance DS1 between the first electrode 191 and the first gate electrode 151 in the first direction (the X direction) may be substantially equal to the second distance DS2 between the second electrode 192 and the first gate electrode 151 in the first direction (the X direction).

Further, the first electrode 191 and the third electrode 193 may be positioned on opposite sides of the second gate electrode 152. Between the first electrode 191 and the third electrode 193, the second gate electrode 152 and the second gate semiconductor layer 182 may be positioned. The second gate electrode 152 and the second gate semiconductor layer 182 may be spaced apart from the first electrode 191 and the third electrode 193 in the second direction (the Y direction). For example, the first electrode 191 may be electrically connected to the main channel layer 132m on one side of the second gate electrode 152 in the second direction (the Y direction), and the third electrode 193 may be electrically connected to the main channel layer 132m on the other side of the second gate electrode 152 in the second direction (the Y direction). The first electrode 191 and the third electrode 193 may be positioned on the outside of the second drift region DTR2 of the main channel layer 132m. The interface between the first electrode 191 and the main channel layer 132m may be one edge of the second drift region DTR2. Similarly, the interface between the third electrode 193 and the main channel layer 132m may be the other edge of the second drift region DTR2. In this case, the third distance DS3 between the first electrode 191 and the second gate electrode 152 in the first direction (the X direction) may be substantially equal to the fourth distance DS4 between the third electrode 193 and the second gate electrode 152 in the first direction (the X direction). Further, the third distance DS3 between the first electrode 191 and the second gate electrode 152 in the first direction (the X direction) may be substantially equal to the first distance DS1 between the first electrode 191 and the first gate electrode 151 in the first direction (the X direction).

However, the present disclosure is not limited thereto, and the first electrode 191 to the third electrode 193 may not be positioned on the outer surfaces of the drift regions DTR1 and DTR2 of the main channel layer 132m. In other words, the main channel layer 132m may not be recessed, and the first electrode 191 to the third electrode 193 may be positioned on the upper surface of the main channel layer 132m.

The first electrode 191 to the third electrode 193 may pass through the first protective layer 140 and the main barrier layer 136m and be positioned inside a trench formed by recessing the upper surface of the main channel layer 132m. Inside the trench, the first electrode 191 to the third electrode 193 may be in contact with the main channel layer 132m and the main barrier layer 136m. The main channel layer 132m may constitute the bottom surface and side walls of the trenches, and the main barrier layer 136m may constitute the side walls of the trench. Accordingly, the first electrode 191 to the third electrode 193 may be in contact with the upper surface and side surface of the main channel layer 132m. Further, the first electrode 191 to the third electrode 193 may be in contact with the side surface of the main barrier layer 136m. In other words, the first electrode 191 to the third electrode 193 may cover the side surfaces of the main channel layer 132m and the main barrier layer 136m.

In some implementations, the first electrode 191 to the third electrode 193 may cover at least a portion of the side surface of the first protective layer 140. For example, the first electrode 191 to the third electrode 193 may cover the side surface of the first protective layer 140. The upper surfaces of the first electrode 191 to the third electrode 193 may protrude from the upper surface of the first protective layer 140. However, the present disclosure is not limited thereto, and the first electrode 191 to the third electrode 193 may cover at least a portion of the side surface of the first protective layer 140, and may not cover the other portion of the side surface of the first protective layer 140. In this case, the other portion of the first protective layer 140 may be positioned on the upper surfaces of the first electrode 191 to the third electrode 193.

The first electrode 191 to the third electrode 193 may contain a conductive material. For example, the first electrode 191 to the third electrode 193 may contain a metal, a metal alloy, a conductive metal nitride, a metal silicide, a doped semiconductor material, a conductive metal oxide, a conductive metal oxynitride, or the like. For example, the first electrode 191 to the third electrode 193 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The first electrode 191 to the third electrode 193 may comprise of a single layer or multiple layers. The first electrode 191 to the third electrode 193 may be in ohmic contact with the main channel layer 132m. The regions in the main channel layer 132m which are in contact with the first electrode 191 to the third electrode 193 may be doped at a relatively higher concentration as compared to the other region.

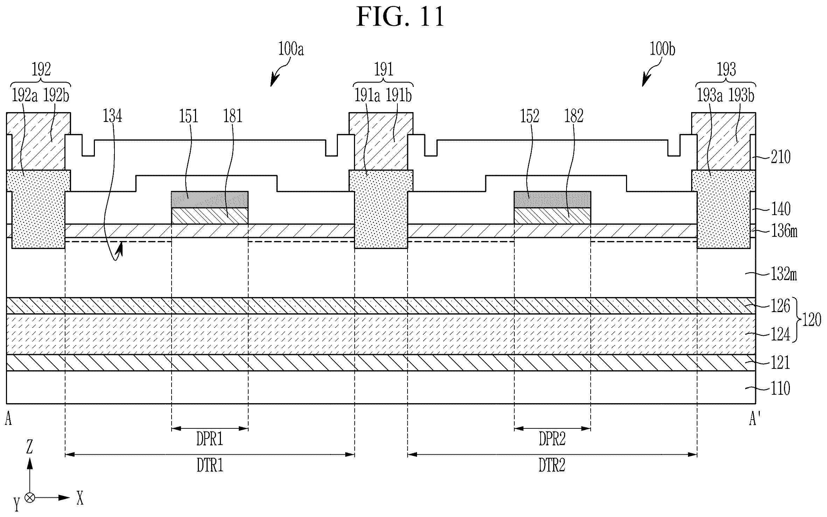

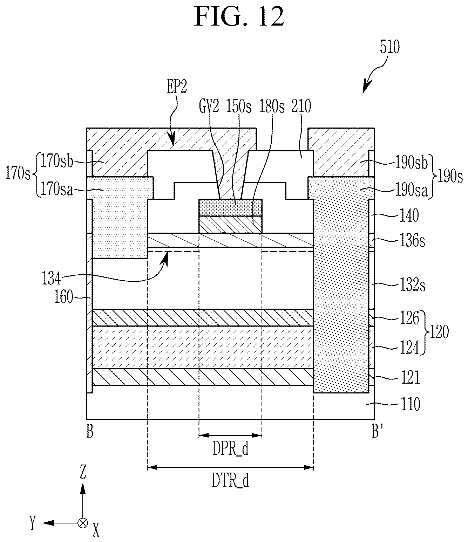

In FIGS. 6 and 7, the first electrode 191 to the third electrode 193 of the semiconductor device 10 comprise a single layer, but the numbers of layers of the first electrode 191 to the third electrode 193 are not limited thereto. For example, the first electrode 191 to the third electrode 193 may include a plurality of electrode layers stacked sequentially in the third direction (the Z direction). This will be described below with reference to FIGS. 11 and 12.

In some implementations, the first electrode 191, the second electrode 192, and the first gate electrode 151 may constitute the first transistor 100a. The first electrode 191, the third electrode 193, and the second gate electrode 152 may constitute the second transistor 100b. When voltages having different magnitudes are applied to the first electrode 191 to the third electrode 193 of the semiconductor device 10, current may flow in the first transistor 100a and/or the second transistor 100b according to the potential differences of the first electrode 191 to the third electrode 193. As an example, when a first voltage is applied to the first electrode 191 and a second voltage smaller than the first voltage is applied to the second electrode 192 and the third electrode 193, according to turn-on signals for the first gate electrode 151 and the second gate electrode 152, current may flow from the first electrode 191 to the second electrode 192 and from the first electrode 191 to the third electrode 193, respectively. Meanwhile, when a third voltage larger than the first voltage is applied to the second electrode 192 and the third electrode 193, according to turn-on signals for the first gate electrode 151 and the second gate electrode 152, current may flow from the second electrode 192 to the first electrode 191 and from the third electrode 193 to the first electrode 191, respectively. Accordingly, when the charger (reference symbol "40" in FIG. 1) is electrically connected to the first electrode 191 and the external devices (reference symbols "31" and "32" in FIG. 1) are electrically connected to the second electrode 192 and the third electrode 193, the external device connected to the second electrode 192 may be charged or discharged according to a turn-on signal for the first gate electrode 151, and the external device connected to the third electrode 193 may be charged or discharged according to a turn-on signal for the second gate electrode 152.

Additionally, the semiconductor device 10 may further include a field dispersion layer that covers at least a portion of the first protective layer 140. The field dispersion layer may be positioned between the first electrode 191 and the second electrode 192 and between the first electrode 191 and the third electrode 193. The field dispersion layer may cover the first gate electrode 151 and the second gate electrode 152. The field dispersion layer may overlap the first gate electrode 151 and the second gate electrode 152 in the third direction (the Z direction).

In some implementations, the field dispersion layer may be electrically connected to at least one of the first electrode 191 to the third electrode 193. The field dispersion layer may contain the same material as that of the first electrode 191 to the third electrode 193, and may be positioned together with the first electrode 191 to the third electrode 193 in the same layer. The field dispersion layer may be formed simultaneously with the first electrode 191 to the third electrode 193 in the same process. In other words, the interfaces between the field dispersion layer and the first electrode 191 to the third electrode 193 may not be clear, and the field dispersion layer may be formed integrally with the first electrode 191 to the third electrode 193. However, the field dispersion layer is not limited thereto, and may be an individual constituent element separated from the first electrode 191 to the third electrode 193.

As another example, the field dispersion layer may be positioned apart from the first electrode 191 to the third electrode 193. In this case, the field dispersion layer may be positioned on the first gate electrode 151 and the second gate electrode 152 and be floated. The field dispersion layer may serve to disperse an electric field concentrated around the first gate electrode 151 and the second gate electrode 152.

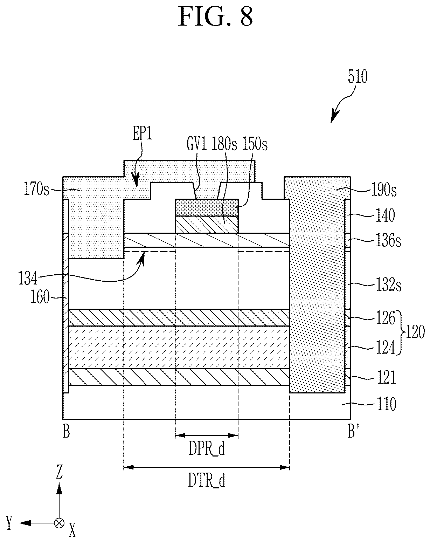

Hereinafter, the plurality of diode elements of the semiconductor device will be described with reference to FIGS. 8 to 10 together.

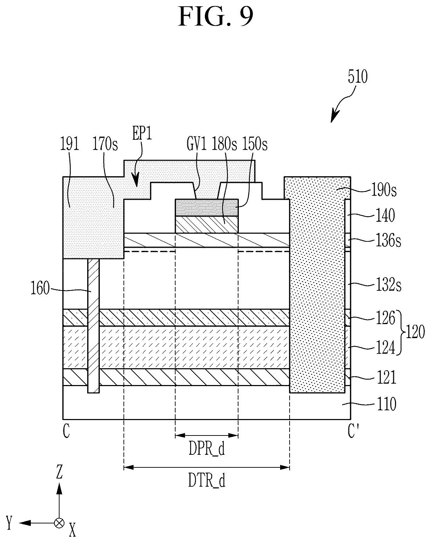

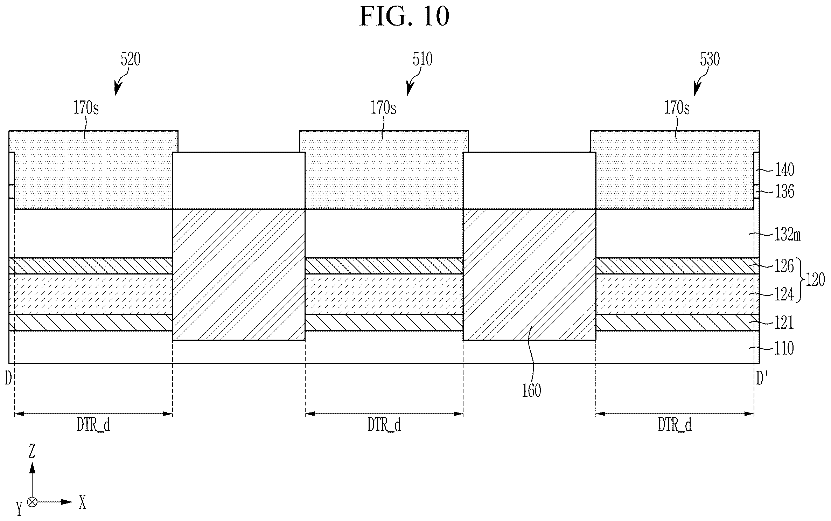

FIG. 8 is a cross-sectional view taken along line B-B' of FIG. 5 according to some implementations. FIG. 9 is a cross-sectional view taken along line C-C' of FIG. 5 according to some implementations. FIG. 10 is a cross-sectional view taken along line D-D' of FIG. 5 according to some implementations. The plurality of diode elements 510, 520, and 530 of the semiconductor device 10 of FIG. 5 and FIGS. 8 to 10 may correspond to the plurality of diode elements 510, 520, and 530 of FIG. 2, respectively.

In FIG. 5, the plurality of diode elements 510, 520, and 530 of the semiconductor device 10 may include the first diode element 510 that electrically connects the first electrode 191 and the substrate 110, the second diode element 520 that electrically connects the second electrode 192 and the substrate 110, and the third diode element 530 that electrically connects the third electrode 193 and the substrate 110.

The plurality of diode elements 510, 520, and 530 may be positioned apart from each other. For example, the plurality of diode elements 510, 520, and 530 may be spaced apart from each other in the first direction (the X direction). In some implementations, the plurality of diode elements 510, 520, and 530 may be separated from each other by a separation structure 160. By the separation structure 160, the plurality of diode elements 510, 520, and 530 may be electrically insulated from each other. In some implementations, the first diode element 510 to the third diode element 530 may have the same structure and shape. Hereinafter, for ease of explanation, the first diode element 510 will be described.

In FIGS. 8 and 9, the first diode element 510 of the semiconductor device 10 may include a sub channel layer 132s positioned on the substrate 110, a sub barrier layer 136s positioned on the sub channel layer 132s, a sub gate electrode 150s positioned on the sub barrier layer 136s, a sub gate semiconductor layer 180s positioned between the sub barrier layer 136s and the sub gate electrode 150s, and a sub source electrode 170s and a sub drain electrode 190s that are positioned on opposite sides of the sub gate electrode 150s.

The sub channel layer 132s may be positioned on the substrate 110. The sub channel layer 132s may be a layer that forms a channel between the sub drain electrode 190s and the sub source electrode 170s, and inside the sub channel layer 132s, a 2-dimensional electron gas (2DEG) 134 may be positioned. In the semiconductor device 10, the 2-dimensional electron gas 134 may occur at the interface between the sub channel layer 132s and the sub barrier layer 136s. For example, the 2-dimensional electron gas 134 may occur at a portion inside the sub barrier layer 136s adjacent to the sub channel layer 132s.

In some implementations, the sub channel layer 132s may be formed integrally with the main channel layer 132m of the bidirectional transistor 100 by the same process. The sub channel layer 132s may be positioned together with the main channel layer 132m in the same layer. The lower surface of the sub channel layer 132s may be positioned at the same level as that of the lower surface of the main channel layer 132m, and the upper surface of the sub channel layer 132s may be positioned at the same level as that of the upper surface of the main channel layer 132m. In other words, the lower surface of the sub channel layer 132s and the lower surface of the main channel layer 132m may be positioned at the same distance from the upper surface of the substrate 110. Further, the upper surface of the sub channel layer 132s and the upper surface of the main channel layer 132m may be positioned substantially at the same distance from the upper surface of the substrate 110. The thickness of the sub channel layer 132s in the third direction (the Z direction) may be substantially equal to the thickness of the main channel layer 132m in the third direction (the Z direction), but the present disclosure is not limited thereto.

In some implementations, the sub channel layer 132s may contain the same material as that of the main channel layer 132m positioned in the main element area MA. As an example, the sub channel layer 132s may contain at least one material selected from III-V materials such as nitrides containing Al, Ga, In, B, or a combination thereof.

The sub channel layer 132s may be positioned on the substrate 110, and between the substrate 110 and the sub channel layer 132s, the seed layer 121 and the buffer layer 120 may be positioned. The substrate 110, the seed layer 121, and the buffer layer 120 may be layers necessary for forming the sub channel layer 132s, and may be omitted in some cases. In the embodiment, the substrate 110, the seed layer 121, and the buffer layer 120 that are positioned in the peripheral circuit area PA may be formed integrally with the substrate 110, the seed layer 121, and the buffer layer 120 that are positioned in the main element area MA by the same processes, respectively.

The sub barrier layer 136s may be positioned on the sub channel layer 132s. The sub barrier layer 136s may be positioned directly on the sub channel layer 132s. However, the present disclosure is not limited thereto, and between the sub channel layer 132s and the sub barrier layer 136s, other predetermined layers may be further positioned. The region of the sub channel layer 132s overlapping the sub barrier layer 136s may become a drift region. Specifically, as the sub barrier layer 136s is different from the sub channel layer 132s in at least one of the polarization characteristic, the energy band gap, and the lattice constant, the 2-dimensional electron gas 134 may be induced in the sub channel layer 132s having relatively low electrical polarizability by the sub barrier layer 136s.

In some implementations, the sub channel layer 132s may include a sub drift region DTR_d between the sub source electrode 170s and the sub drain electrode 190s. In other words, the sub drift region DTR_d may refer to the region of the sub channel layer 132s from one side of the sub channel layer 132s in contact with the sub drain electrode 190s to the sub source electrode 170s. The sub drift region DTR_d may refer to the region of the sub channel layer 132s overlapping the sub barrier layer 136s between the sub source electrode 170s and the sub drain electrode 190s. For example, the boundary between the sub drain electrode 190s and the sub channel layer 132s may be one edge of the sub drift region DTR_d, and the boundary between the sub source electrode 170s and the sub channel layer 132s may be the other edge of the sub drift region DTR_d. In other words, the sub drift region DTR_d may refer to a region in the peripheral circuit area PA between one side of the sub channel layer 132s in contact with the sub drain electrode 190s and the sub source electrode 170s where carriers migrate.

The first protective layer 140 of the semiconductor device 10 according to the embodiment may further extend to the upper surface of the sub barrier layer 136s. The first protective layer 140 may be positioned on the sub barrier layer 136s. The lower surface of the first protective layer 140 may be in contact with the sub barrier layer 136s.

The sub gate electrode 150s may be positioned on the sub barrier layer 136s. In the embodiment, the sub gate electrode 150s may extend in the first direction (the X direction). The sub gate electrode 150s may extend in a direction intersecting the direction in which the first gate electrode 151 and the second gate electrode 152 extend. The sub gate electrode 150s may be covered by the first protective layer 140.

The sub gate electrode 150s may be formed together with the first gate electrode 151 and the second gate electrode 152 in the same process. The sub gate electrode 150s may be positioned together with the first gate electrode 151 and the second gate electrode 152 in the same layer. The sub gate electrode 150s may contain the same material as that of the first gate electrode 151 and the second gate electrode 152.

The sub gate semiconductor layer 180s may be positioned between the sub barrier layer 136s and the sub gate electrode 150s. In other words, the sub gate semiconductor layer 180s may be positioned on the sub barrier layer 136s, and the sub gate electrode 150s may be positioned on the sub gate semiconductor layer 180s. The sub gate electrode 150s may be brought into Schottky contact or ohmic contact with the sub gate semiconductor layer 180s. By the sub gate semiconductor layer 180s, a sub depletion region DPR_d may be formed inside the sub channel layer 132s.

The sub gate semiconductor layer 180s may be formed together with the first gate semiconductor layer 181 and the second gate semiconductor layer 182 in the same process. The sub gate semiconductor layer 180s may be positioned together with the first gate semiconductor layer 181 and the second gate semiconductor layer 182 in the same layer. The sub gate semiconductor layer 180s may contain the same material as that of the first gate semiconductor layer 181 and the second gate semiconductor layer 182.

The sub source electrode 170s and the sub drain electrode 190s may be positioned on opposite sides of the sub gate electrode 150s. The sub source electrode 170s and the sub drain electrode 190s may be spaced apart from each other. The sub source electrode 170s and the sub drain electrode 190s may extend in the first direction (the X direction) and be spaced apart from each other in the second direction (the Y direction). The sub source electrode 170s and the sub drain electrode 190s may extend in a direction intersecting the direction in which the first electrode 191 to the third electrode 193 extend. As an example, the first electrode 191 to the third electrode 193 may extend in the second direction (the Y direction), and the sub source electrode 170s and the sub drain electrode 190s may extend in the first direction (the X direction); however, the present disclosure is not limited thereto.

The sub source electrode 170s and the sub drain electrode 190s may contain a conductive material. The sub source electrode 170s and the sub drain electrode 190s may contain the same material. Further, the sub source electrode 170s and the sub drain electrode 190s may contain the same material as that of the first electrode 191 to the third electrode 193. The sub source electrode 170s and the sub drain electrode 190s may be formed together with the first electrode 191 to the third electrode 193 by the same process. For example, the sub source electrode 170s may contain a metal, a metal alloy, a conductive metal nitride, a metal silicide, a doped semiconductor material, a conductive metal oxide, a conductive metal oxynitride, or the like.

The sub source electrode 170s may be positioned on the sub channel layer 132s. The sub source electrode 170s may be in contact with the sub channel layer 132s, and may be electrically connected to the sub channel layer 132s. The sub source electrode 170s may pass through the first protective layer 140 and the sub barrier layer 136s, and be positioned inside a trench formed by recessing the upper surface of the sub channel layer 132s.

In FIG. 9, the sub source electrode 170s may be formed integrally with the first electrode 191. The sub source electrode 170s may be positioned together with the first electrode 191 in the same layer, and contain the same material as that of the first electrode. The sub source electrode 170s may be formed integrally with the first electrode 191 by the same process, but the present disclosure is not limited thereto.

In some implementations, the sub source electrode 170s may be electrically connected to the sub gate electrode 150s. Specifically, the sub source electrode 170s may include a first connection portion EP1 which is positioned on the first protective layer 140. The first connection portion EP1 may extend on the first protective layer 140 toward the sub gate electrode 150s. Further, the first connection portion EP1 may be positioned on the sub gate electrode 150s, and be positioned inside a first gate via GV1 passing through the first protective layer 140. The first connection portion EP1 may fully fill the first gate via GV1. By the first connection portion EP1, the sub source electrode 170s and the sub gate electrode 150s may be connected to each other. The first connection portion EP1 may overlap the sub gate electrode 150s in the third direction (the Z direction).

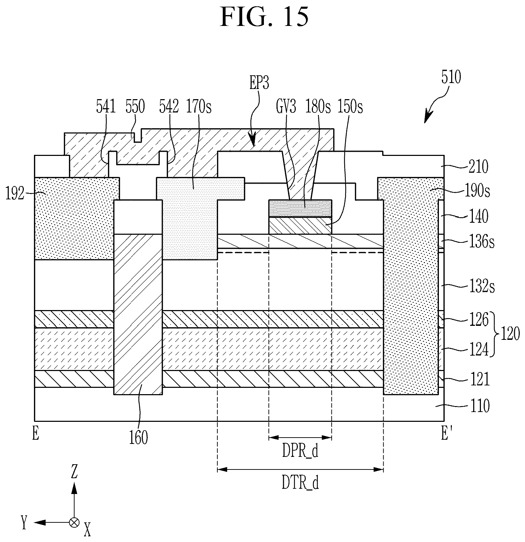

However, the present disclosure is not limited thereto, and, for example, a protective layer may be further positioned between the first connection portion EP1 and the first protective layer 140 and connect the sub source electrode 170s and the sub gate electrode 150s. As another example, the sub source electrode 170s may comprise a plurality of source electrode layers, and a source electrode layer which is positioned at the top may pass through the first protective layer 140 and be connected to the sub gate electrode 150s. As a further example, the sub source electrode 170s and the sub gate electrode 150s may be connected through a separate upper wiring line (reference symbol "550" in FIG. 15) which is positioned on the sub source electrode 170s and the sub gate electrode 150s. This will be described below with reference to FIG. 15.

In some implementations, since the sub source electrode 170s and the sub gate electrode 150s may be electrically connected, signals having voltages having the same magnitude may be applied to the sub source electrode 170s and the sub gate electrode 150s. Accordingly, the first diode element 510 of the semiconductor device 10 may have a diode element characteristic in which current flows in response to a forward voltage and no current flows in response to a reverse voltage.

In some implementations, the sub drain electrode 190s may be positioned on the substrate 110. The sub drain electrode 190s may be connected to the substrate 110. For example, the sub drain electrode 190s may pass through the first protective layer 140, the sub barrier layer 136s, and the sub channel layer 132s, and be positioned inside a trench formed by recessing the upper surface of the substrate 110. Accordingly, the sub drain electrode 190s may be electrically connected to the substrate 110. The side surface of the sub drain electrode 190s may be in contact with the sub barrier layer 136s and the sub channel layer 132s. Further, the sub drain electrode 190s may pass through the seed layer 121 and the buffer layer 120.

The semiconductor device 10 may further include a separation structure 160 which is positioned between the bidirectional transistor 100 and the first diode element 510. The first diode element 510 may be separated from the bidirectional transistor 100 by the separation structure 160. The separation structure 160 may pass through the sub barrier layer 136s, the sub channel layer 132s, the seed layer 121, and the buffer layer 120 and recess at least a portion of the substrate 110. Accordingly, the sub drift region DTR_d of the first diode element 510 may be electrically insulated from the bidirectional transistor 100. However, the present disclosure is not limited thereto, and, as another example, the separation structure 160 may pass through only the sub barrier layer 136s and be positioned on the sub channel layer 132s. As a further example, the separation structure 160 may pass through only the sub barrier layer 136s and the sub channel layer 132s. As a still further example, the separation structure 160 may pass through the sub barrier layer 136s and the sub channel layer 132s and recess at least a portion of the buffer layer 120.

The separation structure 160 may overlap the first electrode 191 to the third electrode 193 in the third direction (the Z direction). The separation structure 160 may be in contact with the lower surfaces of the first electrode 191 to the third electrode 193, but the present disclosure is not limited thereto.

In some implementations, the separation structure 160 may be formed by forming the main barrier layer 136m and the sub barrier layer 136s on the main channel layer 132m and the sub channel layer 132s and performing an ion implantation process on the inside of the sub barrier layer 136s positioned between the bidirectional transistor 100 and the first diode element 510. For example, in the region of the sub channel layer 132s overlapping the main barrier layer 136m and the region of the sub barrier layer 136s subjected to the ion implantation process in the third direction (the Z direction), a 2-dimensional electron gas may not be present or may be rarely formed. In this case, ion implantation regions of the sub barrier layer 136s, the sub channel layer 132s, and the buffer layer 120 may correspond to the separation structure 160. As another example, the separation structure 160 may be formed by performing an ion implantation process on the sub channel layer 132s. The region of the sub channel layer 132s subjected to the ion implantation may correspond to the separation structure 160. The material which is used in the ion implantation process may be argon (Ar) ions. However, the present disclosure is not limited thereto, and the separation structure 160 may be formed by forming the main barrier layer 136m and the sub barrier layer 136s on the main channel layer 132m and the sub channel layer 132s, forming a trench so as to pass through the main barrier layer 136m and the sub barrier layer 136s, and filling the trench with an insulating material. The insulating material constituting the separation structure 160 may contain the same material as that of the first protective layer 140. For example, the insulating material constituting the separation structure 160 may contain an oxide such as SiO₂ or Al₂O₃. As another example, the insulating material constituting the separation structure 160 may contain a nitride, such as SiN, or an oxynitride, such as SiON. However, the insulating material constituting the separation structure 160 is not limited thereto, and may contain a material different from that of the first protective layer 140. In this case, at least a portion of at least one of the main channel layer 132m and the sub channel layer 132s may be recessed as well.

The sub source electrode 170s of the second diode element 520 may be electrically connected to the second electrode 192. The sub source electrode 170s of the second diode element 520 may be formed integrally with the second electrode 192. The sub source electrode 170s of the second diode element 520 may be positioned together with the second electrode 192 in the same layer, and contain the same material as that of the second electrode. The sub drain electrode 190s of the second diode element 520 may pass through the first protective layer 140, the sub barrier layer 136s, and the sub channel layer 132s and be positioned inside a trench formed by recessing the upper surface of the substrate 110. Accordingly, the sub drain electrode 190s of the second diode element 520 may be electrically connected to the substrate 110.

Further, the sub source electrode 170s of the third diode element 530 may be electrically connected to the third electrode 193. The sub source electrode 170s of the third diode element 530 may be formed integrally with the third electrode 193. The sub source electrode 170s of the third diode element 530 may be positioned together with the third electrode 193 in the same layer and contain the same material as that of the third electrode. The sub drain electrode 190s of the third diode element 530 may pass through the first protective layer 140, the sub barrier layer 136s, and the sub channel layer 132s, and be positioned inside a trench formed by recessing the upper surface of the substrate 110. Accordingly, the sub drain electrode 190s of the third diode element 530 may be electrically connected to the substrate 110.

In FIGS. 9 and 10, the plurality of diode elements 510, 520, and 530 may be separated from each other by a separation structure 160. For example, the separation structure 160 may be positioned between the first diode element 510 and the second diode element 520 and between the first diode element 510 and the third diode element 530. By the separation structure 160, the plurality of diode elements 510, 520, and 530 may be electrically insulated from each other. In this case, the sub source electrode 170s of the first diode element 510, the sub source electrode 170s of the second diode element 520, and the sub source electrode 170s of the third diode element 530 may be spaced apart from each other in the first direction (the X direction). The first protective layer 140 may be positioned between the sub source electrode 170s of the first diode element 510 and the sub source electrode 170s of the second diode element 520 and between the sub source electrode 170s of the second diode element 520 and the sub source electrode 170s of the third diode element 530; however, the present disclosure is not limited thereto.

A residual description of the second diode element 520 and the third diode element 530 is substantially identical to the description of the first diode element 510, and will not be made. The second diode element 520 and the third diode element 530 may have the same structure and shape as those of the first diode element 510.

Hereinafter, a resistive element of a semiconductor device will be described with reference to FIGS. 11 to 15.

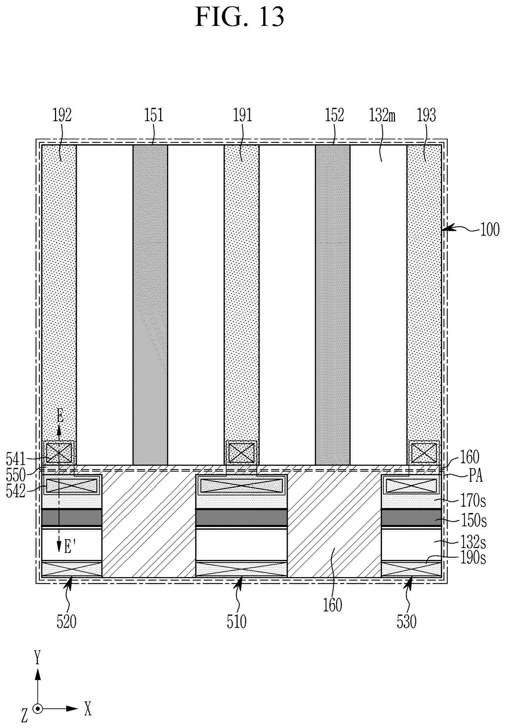

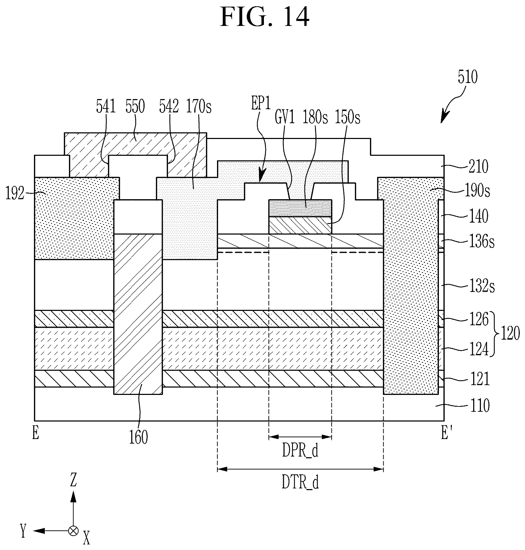

FIG. 11 is a cross-sectional view illustrating an example of a semiconductor device according to some implementations and corresponding to the line A-A' of FIG. 5. FIG. 12 is a cross-sectional view illustrating an example of a semiconductor device according to some implementations and corresponding to the line B-B' of FIG. 5. FIG. 13 is a plan view illustrating an example of a semiconductor device according to some implementations. FIG. 14 is a cross-sectional view taken along line E-E' of FIG. 13 according to some implementations. FIG. 15 is a cross-sectional view illustrating an example of a semiconductor device according to some implementations and corresponding to line E-E' of FIG. 13.

FIGS. 11 to 15 illustrate various implementations of the semiconductor device 10 shown in FIGS. 1 to 10. Since the implementations shown in FIGS. 11 to 15 have many portions identical to those of FIGS. 1 to 10, a description thereof will not be made and the differences will be mainly described. Also, constituent elements identical to those of the above implementations are denoted by the same reference symbols.

In FIG. 11, the first electrode 191 to the third electrode 193 of the semiconductor device 10 may include a plurality of electrode layers stacked in the third direction (the Z direction). For example, the first electrode 191 may include a first lower electrode layer 191a which is positioned on the main channel layer 132m, and a first upper electrode layer 191b which is positioned on the first lower electrode layer 191a. The first lower electrode layer 191a may pass through the first protective layer 140 and the main barrier layer 136m and be in contact with the main channel layer 132m. The first upper electrode layer 191b may pass through a second protective layer 210 and be connected to the first lower electrode layer 191a. The lower surface of the first upper electrode layer 191b may be in contact with the first lower electrode layer 191a.

The second electrode 192 may include a second lower electrode layer 192a which is positioned on the main channel layer 132m, and a second upper electrode layer 192b which is positioned on the second lower electrode layer 192a. The second lower electrode layer 192a may pass through the first protective layer 140 and the main barrier layer 136m and be in contact with the main channel layer 132m. The second upper electrode layer 192b may pass through the second protective layer 210 and be connected to the second lower electrode layer 192a. The lower surface of the second upper electrode layer 192b may be in contact with the second lower electrode layer 192a.

The third electrode 193 may include a third lower electrode layer 193a which is positioned on the main channel layer 132m, and a third upper electrode layer 193b which is positioned on the third lower electrode layer 193a. The third lower electrode layer 193a may pass through the first protective layer 140 and the main barrier layer 136m and be in contact with the main channel layer 132m. The third upper electrode layer 193b may pass through the second protective layer 210 and be connected to the third lower electrode layer 193a. The lower surface of the third upper electrode layer 193b may be in contact with the third lower electrode layer 193a.

The semiconductor device 10 may further include the second protective layer 210 that is positioned on the first protective layer 140. The second protective layer 210 may be positioned on the first protective layer 140, and the first lower electrode layer 191a to the third lower electrode layer 193a. The second protective layer 210 may contain an insulating material. The second protective layer 210 may contain the same material as that of the first protective layer 140, but the present disclosure is not limited thereto. For example, the second protective layer 210 may contain an oxide, such as SiO₂ or Al₂O₃. As another example, the second protective layer 210 may contain a nitride, such as SiN, or an oxynitride, such as SiON.

In FIGS. 11 and 12, the sub source electrode 170s and the sub drain electrode 190s of the semiconductor device 10 may comprise multiple layers. For example, the sub source electrode 170s may include a first sub source electrode 170s which is positioned on the sub channel layer 132s, and a second sub source electrode 170s which is positioned on the first sub source electrode 170s. The first sub source electrode 170s may pass through the first protective layer 140 and the sub barrier layer 136s and be connected to the sub channel layer 132s. The second sub source electrode 170s may pass through the second protective layer 210 and be connected to the first sub source electrode 170s.

In some implementations, the second sub source electrode 170s may be electrically connected to the sub gate electrode 150s. Specifically, the second sub source electrode 170s may include a second connection portion EP2 which is positioned on the second protective layer 210. The second connection portion EP2 may extend on the second protective layer 210 toward the sub gate electrode 150s. Further, the second connection portion EP2 may be positioned on the sub gate electrode 150s, and be positioned inside a second gate via GV2 passing through the second protective layer 210 and the first protective layer 140. The second connection portion EP2 may fully fill the second gate via GV2. By the second connection portion EP2, the first sub source electrode 170s and the sub gate electrode 150s may be connected to each other. The second connection portion EP2 may overlap the sub gate electrode 150s in the third direction (the Z direction).

In some implementations, the second sub source electrode 170s may be positioned together with the first upper electrode layer 191b in the same layer, and contain the same material as that of the first upper electrode layer. The second sub source electrode 170s may be formed integrally with the first upper electrode layer 191b, but the present disclosure is not limited thereto. The second sub source electrode 170s may be formed simultaneously with the first upper electrode layer 191b in the same process. Further, the first sub source electrode 170s may be positioned together with the first lower electrode layer 191a in the same layer, and contain the same material as that of the first lower electrode layer.

Also, the sub drain electrode 190s may include a first sub drain electrode 190s that is positioned on the substrate 110, and a second sub drain electrode 190s that is positioned on the first sub drain electrode 190s. The first sub drain electrode 190s may pass through the first protective layer 140, the sub barrier layer 136s, the sub channel layer 132s, and the buffer layer 120 and be connected to the substrate 110. The second sub drain electrode 190s may pass through the second protective layer 210 and be connected to the first sub drain electrode 190s.

In FIGS. 11 and 12, the first electrode 191 to the third electrode 193, the sub source electrode 170s, and the sub drain electrode 190s are shown comprising of two layers; however, the present disclosure is not limited thereto. For example, the first electrode 191 to the third electrode 193, the sub source electrode 170s, and the sub drain electrode 190s may comprise three or more layers.

In FIGS. 13 to 15, the first electrode 191 of the semiconductor device 10 may be positioned apart from the sub source electrode 170s. In some implementations, the first protective layer 140 may be positioned between the first electrode 191 and the sub source electrode 170s. The separation structure 160 may be positioned between the first electrode 191 and the sub source electrode 170s; however, the present disclosure is not limited thereto.

The semiconductor device 10 may further include an upper wiring line 550 which electrically connects the first electrode 191 and the sub source electrode 170s. The upper wiring line 550 may be positioned on the second protective layer 210 positioned on the first protective layer 140. The upper wiring line 550 may extend in the second direction (the Y direction), but is not limited thereto. The upper wiring line 550 may overlap the first electrode 191 and the sub source electrode 170s in the third direction (the Z direction). The upper wiring line 550 may be in contact with the first electrode 191 and the sub source electrode 170s. In some implementations, the upper wiring line 550 may be positioned inside a first via 541 passing through the second protective layer 210 on the first electrode 191. Further, the upper wiring line 550 may be positioned inside a second via 542 passing through the second protective layer 210 on the sub source electrode 170s. The upper wiring line 550 may fully fill the first via 541 and the second via 542. Accordingly, the upper wiring line 550 may electrically connect the first electrode 191 and the sub source electrode 170s.

In FIG. 15, the upper wiring line 550 of the semiconductor device 10 according to some embodiments may include a third connection portion EP3. The third connection portion EP3 may extend on the second protective layer 210 toward the sub gate electrode 150s. Further, the third connection portion EP3 may be positioned on the sub gate electrode 150s, and be positioned inside a third gate via GV3 passing through the second protective layer 210 and the first protective layer 140. The third connection portion EP3 may fully fill the third gate via GV3. By the third connection portion EP3, the sub source electrode 170s and the sub gate electrode 150s may be connected to each other. The third connection portion EP3 may overlap the sub gate electrode 150s in the third direction (the Z direction); however, the present disclosure is not limited thereto.

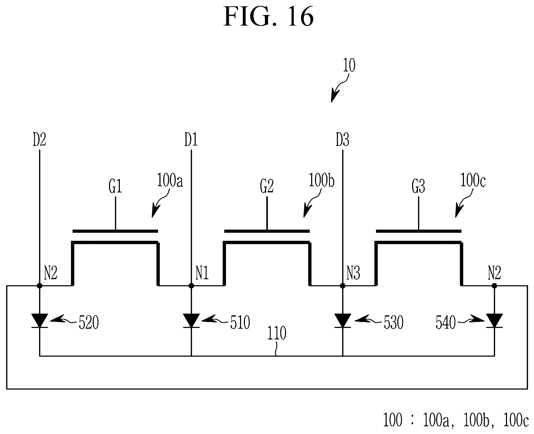

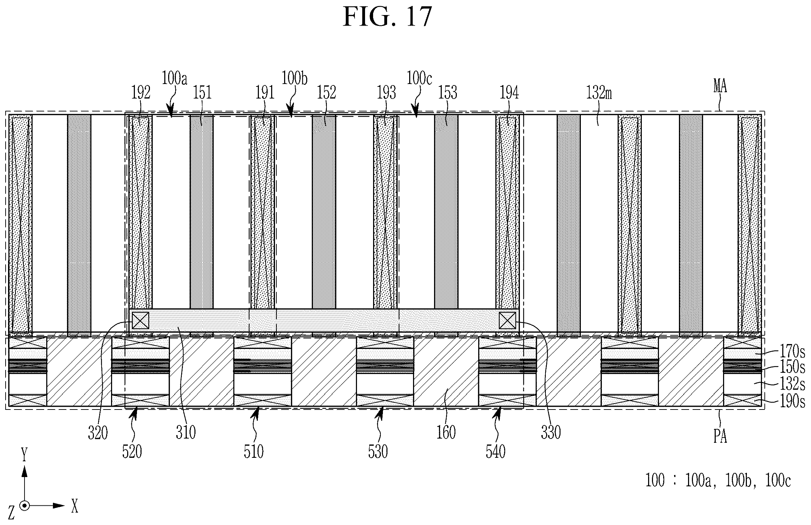

Hereinafter, a resistive element of a semiconductor device will be described with reference to FIGS. 16 and 17.

FIG. 16 is a circuit diagram illustrating an example of a semiconductor device according to some implementations. FIG. 17 is a plan view illustrating an example of a semiconductor device with reference to FIG. 16.

FIGS. 16 and 17 illustrate various implementations of the semiconductor device in FIGS. 1 to 10. Since the implementations shown in FIGS. 16 and 17 have many portions identical to those of FIGS. 1 to 10, a description thereof will not be made and the differences will be mainly described. Also, constituent elements identical to those of the above implementations are denoted by the same reference symbols.

In FIG. 16, the bidirectional transistor 100 of the semiconductor device 10 may further include a third transistor 100c, and a fourth diode element 540 which is electrically connected to the third transistor 100c. In some implementations, the third transistor 100c may comprise a third terminal D3, a second terminal D2, and a third gate electrode G3. In other words, one electrode of the third transistor 100c may be shared with the second transistor 100b, and the other electrode of the third transistor 100c may be shared with the first transistor 100a. The third transistor 100c may control current between the third terminal D3 and the second terminal D2 according to a gate signal which is applied to the third gate electrode G3. In this case, current may bidirectionally flow between the third terminal D3 and the second terminal D2 according to the potential difference between the third terminal D3 and the second terminal D2. In some implementations, the third gate electrode G3 may correspond to the third gate electrode (reference symbol "153" in FIG. 17) of FIG. 17.

The fourth diode element 540 may be electrically connected to one terminal of the third transistor 100c. The fourth diode element 540 may electrically connect the second terminal D2 of the third transistor 100c and the substrate 110.

In FIG. 17, the bidirectional transistor 100 of the semiconductor device 10 may further include a fourth electrode 194, and a connection electrode 310 which electrically connects the third gate electrode 153 and the second electrode 192 to the fourth electrode 194. In some implementations, the fourth electrode 194 and the second electrode 192 may correspond to the third terminal (reference symbol "D3" in FIG. 16) of FIG. 16.

The fourth electrode 194 may be positioned on the main channel layer 132m. The fourth electrode 194 may be positioned apart from the first electrode 191 to the third electrode 193. For example, the fourth electrode 194 may extend in the second direction (the Y direction) and be positioned on one side of the third electrode 193 in the first direction (the X direction). The first electrode 191 to the fourth electrode 194 may be arranged in the first direction (the X direction). For example, the second electrode 192, the first electrode 191, the third electrode 193, and the fourth electrode 194 may be positioned sequentially in the first direction (the X direction). A residual description of the fourth electrode 194 is substantially identical to the description of the first electrode 191 to the third electrode 193 of the implementations of FIGS. 1 to 10, and will not be made.

The third gate electrode 153 may be positioned on the main barrier layer 136m. The third gate electrode 153 may be positioned between the third electrode 193 and the fourth electrode 194. The third gate electrode 153 may extend in a direction parallel with the fourth electrode 194. The third gate electrode 153 may extend in the second direction (the Y direction), but is not limited thereto.

In some implementations, the first electrode 191 and the second electrode 192 may be positioned on opposite sides of the first gate electrode 151, and the third electrode 193 and the fourth electrode 194 may be positioned on opposite sides of the third gate electrode 153. In this case, the second gate electrode 152 may be positioned between the second electrode 192 and the third electrode 193.

The connection electrode 310 may be positioned on the first protective layer 140 positioned on the second electrode 192. The connection electrode 310 may be positioned inside a third via 320 passing through the first protective layer 140 positioned on the second electrode 192, and a fourth via 330 passing through the first protective layer 140 positioned on the fourth electrode 194. The third via 320 may expose the upper surface of the second electrode 192, and the fourth via 330 may expose the upper surface of the fourth electrode 194. The connection electrode 310 may fill the third via 320 and the fourth via 330. Accordingly, the connection electrode 310 may be in contact with the second electrode 192 and the fourth electrode 194. The connection electrode 310 may overlap the second electrode 192 and the fourth electrode 194 in the third direction (the Z direction). In some implementations, the connection electrode 310 may overlap the first electrode 191, the third electrode 193, the first gate electrode 151, the second gate electrode 152, and the third gate electrode 153 in the third direction (the Z direction); however, the present disclosure is not limited thereto. Accordingly, the fourth electrode 194 and the second electrode 192 may be electrically connected to constitute the second electrode (reference symbol "D2" in FIG. 16) of FIG. 16.

In some implementations, the semiconductor device 10 may further include a fourth diode element 540 which is electrically connected to the fourth electrode 194. The fourth diode element 540 may include a sub source electrode 170s, a sub gate electrode 150s, and a sub drain electrode 190s. The sub source electrode 170s of the fourth diode element 540 may be electrically connected to the fourth electrode 194. The sub source electrode 170s of the fourth diode element 540 may be formed integrally with the fourth electrode 194; however, the present disclosure is not limited thereto. The sub source electrode 170s of the fourth diode element 540 may be positioned together with the fourth electrode 194 in the same layer, and contain the same material as that of the fourth electrode. The sub drain electrode 190s of the fourth diode element 540 may pass through the sub barrier layer 136s, the sub channel layer 132s, and the buffer layer 120 and be positioned inside a trench formed by recessing the upper surface of the substrate 110.

In FIGS. 16 and 17, four electrodes 191 to 194 are shown to constitute one bidirectional transistor 100; however, the number of electrodes which constitute the bidirectional transistor 100 is not limited thereto. For example, the bidirectional transistor 100 may comprise five or more electrodes.

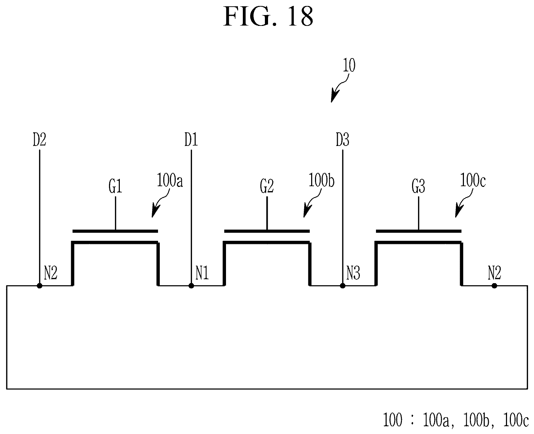

Hereinafter, a resistive element of a semiconductor device will be described with reference to FIGS. 18 to 19.

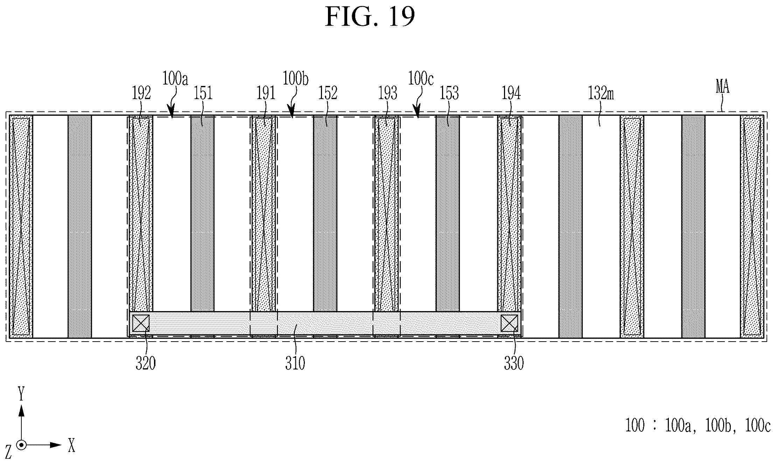

FIG. 18 is a circuit diagram illustrating an example of a semiconductor device according to some implementations. FIG. 19 is a plan view illustrating an example of a semiconductor device according to some implementations with reference to FIG. 18.

FIGS. 18 and 19 illustrate various implementations of the semiconductor device shown in FIGS. 16 and 17. Since the implementations shown in FIGS. 18 and 19 have many portions identical to those of FIGS. 16 and 17, a description thereof will not be made and the differences will be mainly described. Also, constituent elements identical to those of the above implementations are denoted by the same reference symbols.

In FIG. 18, the semiconductor device 10 may include the first transistor 100a, the second transistor 100b, and the third transistor 100c. The first transistor 100a may comprise the first terminal D1, the second terminal D2, and the first gate electrode G1, and the second transistor 100b may comprise the first terminal D1, the third terminal D3, and the second gate electrode G2, and the third transistor 100c may comprise the third terminal D3, the second terminal D2, and the third gate electrode G3. According to turn-on signals for the first to third gate electrodes G1, G2, and G3, current may bidirectionally flow in the first to third transistors 100a, 100b, and 100c. For example, according to a turn-on signal for the first gate electrode G1, current may flow from the first terminal D1 to the second terminal D2, or from the second terminal D2 to the first terminal D1. According to a turn-on signal for the second gate electrode G2, current may flow from the first terminal D1 to the third terminal D3, or from the third terminal D3 to the first terminal D1. According to a turn-on signal for the third gate electrode G3, current may flow from the third terminal D3 to the second terminal D2, or from the second terminal D2 to the third terminal D3.

In FIG. 19, the connection electrode 310 may electrically connect the second electrode 192 and the fourth electrode 194. The connection electrode 310 may be positioned on the first protective layer 140 positioned on the second electrode 192. The connection electrode 310 may be positioned inside the third via 320 passing through the first protective layer 140 positioned on the second electrode 192, and the fourth via 330 passing through the first protective layer 140 positioned on the fourth electrode 194. A residual description of the connection electrode 310 is substantially identical to the description of the connection electrode 310 of FIG. 17, and will not be made.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a substrate (110);
a bidirectional transistor (100) on the substrate (110); and
a plurality of diode elements (510, 520, 520) electrically connected to the bidirectional transistor (100),
wherein the bidirectional transistor (100) comprises:
a main channel layer (132m) on the substrate (110);
a main barrier layer (136m) on the main channel layer (132m), the main barrier layer (136m) comprising a material having an energy band gap different from an energy band gap of the main channel layer (132m);
a first gate electrode (G1, 151) and a second gate electrode (G2, 152) on the main barrier layer (136m), the first gate electrode (G1, 151) and the second gate electrode (G2, 152) being spaced apart from each other;
a first gate semiconductor layer (181) between the main barrier layer (136m) and the first gate electrode (G1, 151);
a second gate semiconductor layer (182) between the main barrier layer (136m) and the second gate electrode (G2, 152);
a first electrode (191) between a first side of the first gate electrode (G1, 151) and a first side of the second gate electrode (G2, 152), the first electrode (191) being electrically connected to the main channel layer (132m);
a second electrode (192) arranged adjacent to a second side of the first gate electrode (G1, 151) and spaced apart from the first gate electrode (G1, 151); and
a third electrode (193) arranged adjacent to a second side of the second gate electrode (G2, 152) and spaced apart from the second gate electrode (G2, 152), and
wherein the plurality of diode elements (510, 520, 520) electrically connects the substrate (110) and the first electrode (191), the substrate (110) and the second electrode (192), and the substrate (110) and the third electrode (193), respectively.

2. The semiconductor device of claim 1,
wherein the first gate electrode (G1, 151) is between the first electrode (191) and the second electrode (192), and
wherein the second gate electrode (G2, 152) is between the first electrode (191) and the third electrode (193).

3. The semiconductor device of claim 2,
wherein a first distance (DS1) between the first gate electrode (G1, 151) and the first electrode (191) is equal to a second distance (DS2) between the first gate electrode (G1, 151) and the second electrode (192), and
wherein a third distance (DS3) between the second gate electrode (G2, 152) and the first electrode (191) is equal to a fourth distance (DS4) between the second gate electrode (G2, 152) and the third electrode (193).

4. The semiconductor device of any one of claims 1 to 3,
wherein each of the plurality of diode elements (510, 520, 520) comprises the following:
a sub channel layer (132s) on the substrate (110);
a sub barrier layer (136s) on the sub channel layer (132s), the sub barrier layer (136s) comprising a material having an energy band gap different from an energy band gap of the sub channel layer (132s);
a sub gate electrode (150s) on the sub barrier layer (136s);
a sub gate semiconductor layer (180s) between the sub barrier layer (136s) and the sub gate electrode (150s); and
a sub source electrode (170s) and a sub drain electrode (190s) on opposite sides of the sub gate electrode (150s), and
wherein the sub source electrode (170s) is electrically connected to the sub gate electrode (180s).

5. The semiconductor device of claim 4, wherein the sub drain electrode (190s) extends into the sub barrier layer (136s) and the sub channel layer (132s) and is connected to the substrate (110).

6. The semiconductor device of claim 4 or 5,
wherein each of the plurality of diode elements (510, 520, 520) furthercomprises a first protective layer (140) on the first gate electrode (G1, 151),
wherein the sub source electrode (170s) comprises a connection portion (EP1) on the first protective layer (140), and
wherein the connection portion (EP1) extends into the first protective layer (140) and is connected to the sub gate electrode (150s).

7. The semiconductor device of any one of claims 4 to 6,
wherein the sub source electrode (170s) and the sub drain electrode (190s) extend in a first direction (X) and are spaced apart from each other in a second direction (Y),
wherein the first electrode (191), the second electrode (192), and the third electrode (193) extend in the second direction (Y), and
wherein the first direction (X) intersects the second direction (Y).

8. The semiconductor device of any one of claims 4 to 7,
wherein the sub channel layer (132s) and the main channel layer (132m) are in a same first layer,
wherein the sub gate electrode (150s), the first gate electrode (G1, 151), and the second gate electrode (G2, 152) are in a same second layer, and
wherein the sub source electrode (170s), the first electrode (191), the second electrode (192), and the third electrode (193) are in a same third layer.

9. The semiconductor device of any one of claims 4 to 8,
wherein the plurality of diode elements (510, 520, 520) comprises a first diode element (510) that electrically connects the substrate (110) and the first electrode (191), and
wherein the sub source electrode (170s) of the first diode element (510) and the first electrode (191) are in a same third layer, and
wherein the sub source electrode (170s) comprises a same material as the first electrode (191).

10. The semiconductor device of claim 9, wherein the sub source electrode (170s) of the first diode element (510) is integral with the first electrode (191).

11. The semiconductor device of claim 9, further comprising a separation structure (160) between the sub source electrode (170s) of the first diode element (510) and the first electrode (191),
wherein the separation structure (160) extends into the main barrier layer (136m) and the main channel layer (132m).

12. The semiconductor device of any one of claims 9 to 11,
wherein the plurality of diode elements (510, 520, 520) comprises:
a second diode element (520) that electrically connects the substrate (110) and the second electrode (192); and
a third diode element (530) that electrically connects the substrate (110) and the third electrode (193),
wherein the sub source electrode (170s) of the second diode element (520) is integral with the second electrode (192), and
wherein the sub source electrode (170s) of the third diode element (530) is integral with the third electrode (193).

13. The semiconductor device of claim 12, further comprising a separation structure (160) that extends into the sub barrier layer (136s),
wherein the separation structure (160) is between the first diode element (510) and the second diode element (520).

14. The semiconductor device of any one of claims 1 to 13, wherein the bidirectional transistor (100) comprises:
a fourth electrode (194) that extends into the main barrier layer (136m), the fourth electrode (194) being on the main channel layer (132m), and spaced apart from the third electrode (193);
a third gate electrode (153) on the main barrier layer (136m), the third gate electrode being between the third electrode (193) and the fourth electrode (194); and
a connection electrode (330) that connects the second electrode (192) and the fourth electrode (194).

15. The semiconductor device of claim 14,
wherein the first electrode (191), the second electrode (192), and the third electrode (193) extend in a second direction (Y), and
wherein the fourth electrode (194) and the third gate electrode (153) extend in the second direction (Y).

## Amended claims

### Amended claims in accordance with Rule 137(2) EPC.

1. A semiconductor device comprising:
a substrate (110);
a bidirectional transistor (100) on the substrate (110); and
a plurality of diode elements (510, 520, 530) electrically connected to the bidirectional transistor (100), the plurality of diode elements (510, 520, 530) comprising a first diode element (510), a second diode element (520) and a third diode element (530),
wherein the bidirectional transistor (100) comprises:
a main channel layer (132m) on the substrate (110);
a main barrier layer (136m) on the main channel layer (132m), the main barrier layer (136m) comprising a material having an energy band gap different from an energy band gap of the main channel layer (132m);
a first gate electrode (G1, 151) and a second gate electrode (G2, 152) on the main barrier layer (136m), the first gate electrode (G1, 151) and the second gate electrode (G2, 152) being spaced apart from each other;
a first gate semiconductor layer (181) between the main barrier layer (136m) and the first gate electrode (G1, 151);
a second gate semiconductor layer (182) between the main barrier layer (136m) and the second gate electrode (G2, 152);
a first electrode (191) between a first side of the first gate electrode (G1, 151) and a first side of the second gate electrode (G2, 152), the first electrode (191) being electrically connected to the main channel layer (132m);
a second electrode (192) arranged adjacent to a second side of the first gate electrode (G1, 151) and spaced apart from the first gate electrode (G1, 151); and
a third electrode (193) arranged adjacent to a second side of the second gate electrode (G2, 152) and spaced apart from the second gate electrode (G2, 152), and
**characterized in that** a cathode (512) of the first diode element (510) is electrically connected to the substrate (110) and an anode (511) of the first diode element (510) is electrically connected to the first electrode (191), a cathode (522) of the second diode element (520) is electrically connected to the substrate (110) and an anode (521) of the second diode element (520) is electrically connected to the second electrode (192), and a cathode (532) of the third diode element (530) is electrically connected to the substrate (110) and an anode (531) of the third diode element (530) is electrically connected to the third electrode (193).

2. The semiconductor device of claim 1,
wherein the first gate electrode (G1, 151) is between the first electrode (191) and the second electrode (192), and
wherein the second gate electrode (G2, 152) is between the first electrode (191) and the third electrode (193).

3. The semiconductor device of claim 2,
wherein a first distance (DS1) between the first gate electrode (G1, 151) and the first electrode (191) is equal to a second distance (DS2) between the first gate electrode (G1, 151) and the second electrode (192), and
wherein a third distance (DS3) between the second gate electrode (G2, 152) and the first electrode (191) is equal to a fourth distance (DS4) between the second gate electrode (G2, 152) and the third electrode (193).

4. The semiconductor device of any one of claims 1 to 3,
wherein each of the plurality of diode elements (510, 520, 530) comprises the following:
a sub channel layer (132s) on the substrate (110);
a sub barrier layer (136s) on the sub channel layer (132s), the sub barrier layer (136s) comprising a material having an energy band gap different from an energy band gap of the sub channel layer (132s);
a sub gate electrode (150s) on the sub barrier layer (136s);
a sub gate semiconductor layer (180s) between the sub barrier layer (136s) and the sub gate electrode (150s); and
a sub source electrode (170s) and a sub drain electrode (190s) on opposite sides of the sub gate electrode (150s), and
wherein the sub source electrode (170s) is electrically connected to the sub gate electrode (180s).

5. The semiconductor device of claim 4, wherein the sub drain electrode (190s) extends into the sub barrier layer (136s) and the sub channel layer (132s) and is connected to the substrate (110).

6. The semiconductor device of claim 4 or 5,
wherein each of the plurality of diode elements (510, 520, 530) further comprises a first protective layer (140) on the respective sub gate electrode (150s),
wherein the sub source electrode (170s) comprises a connection portion (EP1) on the first protective layer (140), and
wherein the connection portion (EP1) extends into the first protective layer (140) and is connected to the sub gate electrode (150s).

7. The semiconductor device of any one of claims 4 to 6,
wherein the sub source electrode (170s) and the sub drain electrode (190s) extend in a first direction (X) and are spaced apart from each other in a second direction (Y),
wherein the first electrode (191), the second electrode (192), and the third electrode (193) extend in the second direction (Y), and
wherein the first direction (X) intersects the second direction (Y).

8. The semiconductor device of any one of claims 4 to 7,
wherein the sub channel layer (132s) and the main channel layer (132m) are in a same first layer,
wherein the sub gate electrode (150s), the first gate electrode (G1, 151), and the second gate electrode (G2, 152) are in a same second layer, and
wherein the sub source electrode (170s), the first electrode (191), the second electrode (192), and the third electrode (193) are in a same third layer.

9. The semiconductor device of any one of claims 4 to 7,
wherein the sub source electrode (170s) of the first diode element (510) and the first electrode (191) are in a same third layer, and
wherein the sub source electrode (170s) comprises a same material as the first electrode (191).

10. The semiconductor device of claim 9, wherein the sub source electrode (170s) of the first diode element (510) is integral with the first electrode (191).

11. The semiconductor device of claim 9, further comprising a separation structure (160) between the sub source electrode (170s) of the first diode element (510) and the first electrode (191),
wherein the separation structure (160) extends into the main barrier layer (136m) and the main channel layer (132m).

12. The semiconductor device of any one of claims 9 to 11,
wherein the sub source electrode (170s) of the second diode element (520) is integral with the second electrode (192), and
wherein the sub source electrode (170s) of the third diode element (530) is integral with the third electrode (193).

13. The semiconductor device of claim 12, further comprising a separation structure (160) that separates two adjacent sub barrier layers (136s),
wherein the separation structure (160) is between the first diode element (510) and the second diode element (520).

14. The semiconductor device of any one of claims 1 to 13, wherein the bidirectional transistor (100) comprises:
a fourth electrode (194) that extends into the main barrier layer (136m), the fourth electrode (194) being on the main channel layer (132m), and spaced apart from the third electrode (193);
a third gate electrode (153) on the main barrier layer (136m), the third gate electrode being between the third electrode (193) and the fourth electrode (194); and
a connection electrode (330) that connects the second electrode (192) and the fourth electrode (194).

15. The semiconductor device of claim 14,
wherein the first electrode (191), the second electrode (192), the third electrode (193),
the fourth electrode (194) and the third gate electrode (153) extend in the same direction (Y).
